# EUROPEAN PATENT SPECIFICATION

(11) **EP 4 131 374 B1**
(45) Date of publication and mention of the grant of the patent: **03.06.2026**
(21) Application number: 20931045.7
(22) Date of filing: 17.04.2020
(51) Int. Cl.: H01L 23/538, H01L 21/768, H01L 23/48, H01L 25/065, H01L 23/00, H10F 39/00

(54) **SEMICONDUCTOR STRUCTURE AND MANUFACTURING METHOD THEREFOR**
HALBLEITERSTRUKTUR UND HERSTELLUNGSVERFAHREN DAFÜR
STRUCTURE SEMI-CONDUCTRICE ET SON PROCÉDÉ DE FABRICATION

(43) Date of publication of application: 08.02.2023
(73) Proprietor: Huawei Technologies Co., Ltd., Shenzhen, Guangdong 518129 (CN)
(72) Inventor: HE, Ran, Shenzhen, Guangdong 518129 (CN); HO, Chihon, Shenzhen, Guangdong 518129 (CN)
(74) Representative: Gill Jennings & Every LLP
(86) International application number: PCT/CN2020/085375
(87) International publication number: WO 2021/208078

(56) References cited:
- EP-A1- 3 293 757
- EP-A2- 2 648 215
- WO-A1-2013/184880
- CN-A- 104 051 423
- CN-A- 104 377 164
- CN-A- 109 148 360
- CN-A- 109 192 747
- CN-A- 109 449 091
- US-A1- 2019 198 552
- US-B1- 9 748 175

## Description

### TECHNICAL FIELD

This application relates to the field of semiconductor manufacturing technologies, and in particular, to a semiconductor structure and a manufacturing method thereof.

### BACKGROUND

In recent years, a semiconductor device and an integrated circuit have rapidly increasing integration density and power density. In this case, plane space is limited, and a Moore's law comes to a bottleneck. A three-dimensional stacking technology is a current mainstream breakthrough solution. A multi-layer structure or a 3D structure may be formed by using the three-dimensional stacking technology. The 3D structure is, for example, a three-dimensional integrated circuit (3D-IC), a micro-electro-mechanical system (MEMS), or a complementary metal-oxide-semiconductor (CMOS) image sensor (CIS). In the three-dimensional stacking technology, bonding is a core process that experiences a technology iteration process from a micro-bump bonding technology, to a copper pillar bonding technology, and to a wafer bonding technology. Currently, the three-dimensional stacking technology is centered on the wafer bonding technology. The wafer bonding technology has been developed into a competition key of each manufacturer in the three-dimensional stacking technology.

The wafer bonding is a technology for fitting surfaces of wafers to form a mechanical connection and an electrical connection. Dielectric layer bonding is a wafer bonding implementation of a wafer bonding technology for forming a covalent bond between dielectric layers. In this case, an electric connection is not implemented between two bonded wafers. To implement an interconnection between wafers through dielectric layer bonding, a through silicon via (TSV) technology may be used. In the TSV technology, a through hole is formed on a back surface of a wafer, and a conductive material is filled in the through hole, to implement a vertical interconnection between wafers. For example, two through holes are separately disposed on different wafers, and the conductive material is filled in the through holes, to obtain contact plugs separately connected to the two wafers. Then, a connection wire separately connected to the two wafers is further disposed, to implement a connection between different wafers. In this manner, the contact plugs and the connection wire are used between the two wafers to implement a connection. A wire between the two wafers is relatively long, causing a relatively large signal delay. In this case, an actual requirement cannot be met in some scenarios. In addition, a three-dimensional interconnection is implemented by using a plurality of contact plugs, occupying relatively large plane space. This does not facilitate improvement of integration density of a device.

EP 3 293 757 A1 is related to a method for bonding and interconnecting two or more IC devices (10a,10b) arranged on substrates such as silicon wafers.

US 2019/198552 A1 discloses a semiconductor device including via plug.

EP 2 648 215 A2 describes a method and apparatus providing integrated circuit system with interconnected stacked device wafers.

WO 2013/184880 A1 discloses a three-dimensional (3D) integrated circuit assembly has chips bonded in face-against-face configuration, via passing through chips, and cushion layer which encapsulates via portion and formed between via and material surrounding via.

### SUMMARY

In view of this, a first aspect of this application provides a semiconductor structure as defined in claim 1 and a manufacturing method thereof as defined in claim 7, to reduce a signal delay between wafers.

In a possible implementation, the second connection pad is disposed opposite to the first connection pad in a vertical direction, and the sidewall on at least one side of the second connection pad exceeds the sidewall of the first connection pad in a horizontal direction. In this case, the vertical through hole exposes the upper surface adjacent to the sidewall on the at least one side of the second connection pad, or the adjacent upper surface and the sidewall on the at least one side of the second connection pad.

In this embodiment of this application, the sidewall on the at least one side of the second connection pad exceeds the sidewall of the first connection pad in the horizontal direction. In this case, the vertical through hole may expose at least the upper surface that is of the second connection pad and that is adjacent to the sidewall exceeding the first connection pad, to implement contact between the contact plug and the second connection pad. Certainly, the vertical through hole further exposes the sidewall that is of the second connection pad and that exceeds the sidewall of the first connection pad, to improve contact reliability between the contact plug and the second connection pad to some extent, thereby improving reliability of the electrical connection between the first connection pad and the second connection pad.

In the vertical through hole, the first dielectric layer is reserved on the sidewall of the first connection pad.

The vertical through hole may not expose the sidewall of the first connection pad. Instead, the first dielectric layer on the sidewall of the first connection pad is reserved in an etching process. In this way, the first dielectric layer may protect the sidewall of the first connection pad, to improve structure integrity of the first connection pad and further improve function integrity of the first connection pad.

In a possible implementation, the second connection pad is disposed opposite to the first connection pad in a vertical direction, and the sidewall on at least one side of the second connection pad is flush with the sidewall of the first connection pad. In this case, the vertical through hole exposes the sidewall on the at least one side of the second connection pad and the sidewall that is of the first connection pad and that is flush with the second connection pad.

In this embodiment of this application, the sidewall on the at least one side of the second connection pad is flush with the sidewall of the first connection pad. In this case, the sidewall of the first connection pad and the sidewall of the second connection pad may be exposed by using the vertical through hole, so that the sidewall of the first connection pad is connected to the sidewall of the second connection pad by using the contact plug, to implement the electrical connection between the first connection pad and the second connection pad. Therefore, a redundant horizontal area of a vertical interconnection structure is reduced, to reduce a device area and improve device integration.

In a possible implementation, the second connection pad and the first connection pad are disposed in a staggered manner in the vertical direction. A size of a top opening of the vertical through hole is greater than or equal to a horizontal distance between the second connection pad and the first connection pad.

In this embodiment of this application, the second connection pad and the first connection pad may be disposed in the staggered manner in the vertical direction. In this case, there is no overlapping region between the first connection pad and the second connection pad in the vertical direction, and there is the horizontal distance between the first connection pad and the second connection pad in the horizontal direction. In this case, the size of the top opening of the vertical through hole may be greater than or equal to the horizontal distance between the second connection pad and the first connection pad, to successfully expose the first connection pad and the second connection pad, thereby implementing the electrical connection between the first connection pad and the second connection pad and improving reliability of the electrical connection.

In a possible implementation, the semiconductor device further includes a third wafer.

The third wafer has a third connection pad. The third wafer is bonded to the first wafer, to implement an electrical connection between the third connection pad and the contact plug.

In this embodiment of this application, the semiconductor device may further include the third wafer. The third connection pad of the third wafer may be electrically connected to the contact plug, and further connected to the first wafer and the second wafer. Specifically, the third wafer may be bonded to the first wafer, to further improve device integration.

In a possible implementation, the vertical through hole passes through a direction of the sidewall on a plurality of sides of the first connection pad.

In this embodiment of this application, the vertical through hole may pass through the directions of the sidewall on the plurality of sides of the first connection pad. In this way, the contact plug formed in the vertical through hole may enclose the first connection pad on the plurality of sides, to improve contact reliability between the contact plug and the first connection pad, increase a contact area between the contact plug and the second connection pad to some extent, and improve contact reliability between the contact plug and the second connection pad.

In a possible implementation, the second connection pad is disposed opposite to the first connection pad in a vertical direction. The using the first connection pad as a blocking layer, and etching the first wafer from top to bottom to form a vertical through hole includes:
performing etching from an upper surface of the first wafer to obtain a first opening, where the first opening is located above the first connection pad, and a sidewall on at least one side of the first opening exceeds the sidewall of the first connection pad in a horizontal direction;
forming a second opening by etching a bottom in a position in which the sidewall of the first opening exceeds the sidewall of the first connection pad in the horizontal direction; and
using the first connection pad as the blocking layer, and deepening the first opening and the second opening, so that the deepened first opening exposes the upper surface of the first connection pad, and the deepened second opening exposes the upper surface and the sidewall of the second connection pad.

In a possible implementation, when the sidewall of the first opening exceeds the sidewall of the first connection pad in the horizontal direction, the sidewall on at least one side of the second connection pad exceeds the sidewall of the first connection pad in the horizontal direction. In this case, the deepened second opening exposes the upper surface adjacent to the sidewall that is of the second connection pad and that exceeds the sidewall of the first connection pad in the horizontal direction, or the sidewall that is of the second connection pad and that exceeds the sidewall of the first connection pad in the horizontal direction and the upper surface adjacent to the sidewall of the second connection pad.

And when the sidewall of the first opening exceeds the sidewall of the first connection pad in the horizontal direction, the sidewall on at least one side of the second connection pad is flush with the sidewall of the first connection pad. In this case, the deepened second opening exposes the sidewall that is of the second connection pad and that is flush with the first connection pad.

In the invention, when the sidewall of the second connection pad exceeds the sidewall of the first connection pad in the horizontal direction, the first dielectric layer is reserved on the sidewall of the first connection pad in the deepened second opening.

In a possible implementation, the second connection pad is disposed opposite to the first connection pad in a vertical direction. The first dielectric layer has a third opening. The using the first connection pad as a blocking layer, and etching the first wafer from top to bottom to form a vertical through hole includes:
performing etching from an upper surface of the first wafer to obtain a first opening, where the first opening is located above the first connection pad, and a sidewall on at least one side of the first opening exceeds the sidewall of the first connection pad in a horizontal direction; and
using the first connection pad as the blocking layer, and etching the first dielectric layer and the second dielectric layer at a bottom of the first opening, so that the deepened first opening is connected to the third opening, the third opening is deepened in the etching process, the deepened first opening exposes the upper surface of the first connection pad, and the deepened third opening exposes the upper surface and
the sidewall of the second connection pad.

In a possible implementation, when the sidewall of the first opening exceeds the sidewall of the first connection pad in the horizontal direction, the sidewall on at least one side of the second connection pad exceeds the sidewall of the first connection pad in the horizontal direction. The deepened third opening exposes the upper surface adjacent to the sidewall that is of the second connection pad and that exceeds the sidewall of the first connection pad in the horizontal direction, or the sidewall that is of the second connection pad and that exceeds the sidewall of the first connection pad in the horizontal direction and the upper surface adjacent to the sidewall of the second connection pad.

And/or, when the sidewall of the first opening exceeds the sidewall of the first connection pad in the horizontal direction, the sidewall on at least one side of the second connection pad is flush with the sidewall of the first connection pad. In this case, the deepened third opening exposes the sidewall that is of the second connection pad and that is flush with the first connection pad.

In a possible implementation, when the sidewall of the second connection pad exceeds the sidewall of the first connection pad in the horizontal direction, the first dielectric layer is reserved on the sidewall of the first connection pad in the deepened third opening.

In a possible implementation, the second connection pad is disposed opposite to the first connection pad in a vertical direction. The using the first connection pad as a blocking layer, and etching the first wafer from top to bottom to form a vertical through hole includes:
performing etching from an upper surface of the first wafer to obtain a first opening, where the first opening is located above the first connection pad, and a sidewall on at least one side of the first opening exceeds the sidewall of the first connection pad in a horizontal direction; and
using the first connection pad as the blocking layer, and deepening the first opening, so that the deepened first opening exposes the upper surface of the first connection pad, and the upper surface and
the sidewall of the second connection pad.

In a possible implementation, when the sidewall of the first opening exceeds the sidewall of the first connection pad in the horizontal direction, the sidewall on at least one side of the second connection pad exceeds the sidewall of the first connection pad in the horizontal direction. The deepened first opening exposes the upper surface adjacent to the sidewall that is of the second connection pad and that exceeds the sidewall of the first connection pad in the horizontal direction, or the sidewall that is of the second connection pad and that exceeds the sidewall of the first connection pad in the horizontal direction and the upper surface adjacent to the sidewall of the second connection pad.

And/or, when the sidewall of the first opening exceeds the first connection pad in the horizontal direction, the sidewall on at least one side of the second connection pad is flush with the sidewall of the first connection pad. In this case, the deepened first opening exposes the sidewall that is of the second connection pad and that is flush with the first connection pad.

In a possible implementation, the second connection pad is disposed opposite to the first connection pad in a vertical direction. The using the first connection pad as a blocking layer, and etching the first wafer from top to bottom to form a vertical through hole includes:
performing etching from an upper surface of the first wafer to obtain a fourth opening, where a sidewall on at least one side of the fourth opening exceeds the sidewall of the first connection pad; and
using the first connection pad as the blocking layer, and performing etching above the first connection pad and on a bottom of the fourth opening to expose the upper surface of the first connection pad, where the deepened fourth opening exposes the upper surface and the sidewall of the second connection pad.

In a possible implementation, when the sidewall of the fourth opening exceeds the sidewall of the first connection pad in the horizontal direction, the sidewall on at least one side of the second connection pad exceeds the sidewall of the first connection pad in the horizontal direction. The deepened fourth opening exposes the upper surface adjacent to the sidewall that is of the second connection pad and that exceeds the sidewall of the first connection pad in the horizontal direction, or the sidewall that is of the second connection pad and that exceeds the sidewall of the first connection pad in the horizontal direction and the upper surface adjacent to the sidewall of the second connection pad.

And/or, when the sidewall of the fourth opening exceeds the sidewall of the first connection pad in the horizontal direction, the sidewall on at least one side of the second connection pad is flush with the sidewall of the first connection pad. In this case, the deepened fourth opening exposes the sidewall that is of the second connection pad and that is flush with the first connection pad.

In a possible implementation, the filling a conductive material in the vertical through hole to form a contact plug includes:
filling the conductive material in the vertical through hole and on the upper surface of the first wafer by using an electroplating process or a deposition process; and
removing the conductive material on the upper surface of the first wafer by using a planarization process, to form the contact plug in the vertical through hole.

In comparison with the conventional technologies, this application has the following beneficial effects:

It can be learned from the foregoing technical solutions that this application provides a semiconductor device and a manufacturing method thereof according to claims 1 and 7. Etching is not performed on the first dielectric layer located below the first connection pad. In other words, the vertical through hole may expose the upper surface of the first wafer and the upper surface and the sidewall of the second connection pad. In this way, the contact plug in the vertical through hole may be in contact with both the first connection pad and the second connection pad, to implement an electrical connection between the first connection pad and the second connection pad. The contact plug is used as a signal transmission path between the first connection pad and the second connection pad. This path is relatively short. Therefore, a signal delay is reduced. In addition, the vertical through hole is formed by using an etching process, and passes through a sidewall of the first connection pad to the second connection pad. The contact plug may be in contact with the second connection pad from the periphery of the first connection pad, to implement a reliable connection between the contact plug and the second connection pad by using a simple process. In addition, in this embodiment of this application, only one metal plug exists, and therefore, a distance between two metal plugs does not need to be considered. Therefore, a horizontal dimension may be reduced to some extent, to reduce a device size and improve device integration.

### BRIEF DESCRIPTION OF DRAWINGS

To clearly understand specific implementations of this application, the following briefly describes accompanying drawings used for describing the specific implementations of this application. Apparently, the accompanying drawings show merely some embodiments of this application.
FIG. 1 is a schematic diagram of a bonding structure in the conventional technologies;
FIG. 2 is a top view of a three-dimensional interconnection structure in the conventional technologies;
FIG. 3 is a schematic diagram of a structure of a semiconductor device according to an embodiment of this application;
FIG. 4 is a schematic diagram of shapes of a first connection pad and a second connection pad according to an embodiment of this application;
FIG. 5 is a schematic diagram of a structure of a semiconductor device according to an embodiment of this application;
FIG. 6 is a schematic diagram of a structure of another semiconductor device according to an embodiment of this application;
FIG. 7 is a schematic diagram of a structure of still another semiconductor device according to an embodiment of this application;
FIG. 8 is a schematic diagram of a structure of a three-dimensional interconnection structure according to an embodiment of this application;
FIG. 9 is a top view of a three-dimensional interconnection structure according to an embodiment of this application;
FIG. 10 is a schematic diagram of a structure of a semiconductor embodiment according to the invention;
FIG. 11 is a schematic diagram of other shapes of a first connection pad and a second connection pad according to an embodiment of this application;
FIG. 12 is a schematic diagram of a structure of still yet another semiconductor device according to an embodiment of this application;
FIG. 13 is a schematic diagram of a structure of a further semiconductor device according to an embodiment of this application;
FIG. 14 is a schematic diagram of a structure of still further semiconductor device according to an embodiment of this application;
FIG. 15 is a flowchart of a manufacturing method of a semiconductor device according to an embodiment of this application; and
FIG. 16 to FIG. 20 are schematic diagrams of a semiconductor device in a manufacturing process of the semiconductor device according to an embodiment of this application.

### DESCRIPTION OF EMBODIMENTS

To make the foregoing objectives, features, and advantages of this application clearer and more comprehensible, the following describes specific implementations of this application in more detail with reference to accompanying drawings.

In the following descriptions, many specific details are described to facilitate full understanding of this application. However, this application may also be implemented in another manner different from that described herein, and a person skilled in the art may make similar promotion without violating a connotation of this application. Therefore, this application is not limited to the specific embodiments disclosed below.

In addition, this application is described in detail with reference to schematic diagrams. When the embodiments of this application are described in detail, for ease of description, a cross section diagram indicating a device structure is not partially enlarged according to a general scale. The schematic diagrams are merely examples, and shall not limit the protection scope of this application. In addition, three-dimensional spatial dimensions of length, width, and depth need to be considered in the actual manufacturing.

In view of this, this application provides a semiconductor device and a manufacturing method thereof, to reduce a signal delay and an occupied area, thereby improving integration density of a device.

As described in the background, different wafers can be bonded by using a three-dimensional stacking technology, to reduce plane space of a three-dimensional device and improve the integration density.

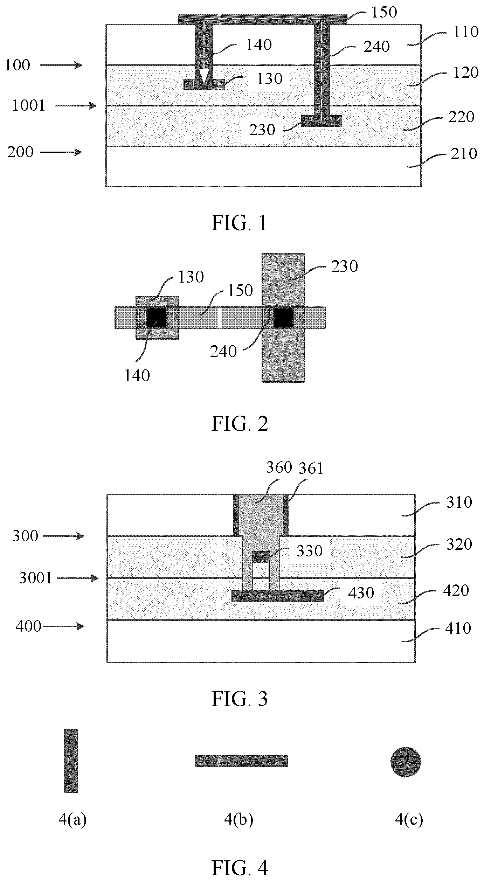

For example, FIG. 1 is a schematic diagram of a bonding structure in the conventional technologies. A first device 130 may be formed in a first wafer 100. The first device 130 may be, for example, a CIS. A second device 230 may be formed in a second wafer 200. The second device 230 may be, for example, an image system processor (ISP). Then the first wafer 100 is bonded to the second wafer 200, to form an image sensor system. The first device is formed in a dielectric layer 120 on a substrate 110. The second device is formed in a dielectric layer 220 on a substrate 210. A bonding surface 1001 is formed between the first wafer 100 and the second wafer 200 that are bonded.

Specifically, dielectric layer bonding may be performed between the first wafer 100 and the second wafer 200. Etching is performed from the substrate 110 of the first wafer 100 by using a through silicon via technology, to form a through silicon via to the CIS and a through silicon via to the ISP. After a metal material is filled in the two through silicon vias, two metal plugs 140 and 240 respectively connected to the CIS and the ISP are obtained. The metal plugs 140 and 240 can be used to implement signal transmission in the bonding structure in a vertical direction. Then, a horizontal redistribution layer (RDL) 150 is formed on a back surface of the substrate 110 of the first wafer 100, to implement an electrical connection between the two metal plugs 140 and 240 and further implement an electrical connection between the redistribution layer 150 and each of the CIS and the ISP through the two metal plugs 140 and 240. In other words, a three-dimensional interconnection is implemented between different layers of wafers.

However, in a manner of implementing a connection through dielectric layer bonding and the through silicon via technology, a signal of the ISP in the second wafer 200 needs to be first transmitted upward through the metal plug 240 connected to the ISP, transmitted to the metal plug 140 connected to the ISP through the horizontal redistribution layer 150, and then transmitted downward to the CIS in the first wafer 100. With reference to a direction indicated by using a dashed line in FIG. 1, the signal needs to pass through a relatively long π-shape path. A delay is related to resistance and capacitance on the path. Therefore, the signal transmission has a relatively large delay. In some scenarios, an actual requirement cannot be met. In addition, two metal plugs are needed to implement the connection between the CIS and the ISP. FIG. 2 is a top view of a three-dimensional interconnection structure in the conventional technologies. Minimum values of sizes of the two metal plugs 140 and 240 are limited. A minimum distance between the two metal plugs 140 and 240 in the manufacturing process is also limited. This indicates that relatively large plane space is required to dispose the two metal plugs 140 and 240. Correspondingly, connection layers of the first device 130 and the second device 230 respectively in contact with the metal plugs 140 and 240 cannot be excessively close. Therefore, integration density of the device in this connection manner is affected.

Based on the foregoing technical problems, the embodiments of this application provide a semiconductor device and a manufacturing method thereof. The semiconductor device may include a first wafer, a second wafer, and a contact plug. The first wafer may include a first dielectric layer. The first dielectric layer has a first connection pad. The second wafer is bonded to the first wafer. The second wafer includes a second dielectric layer. The second dielectric layer has a second connection pad. The contact plug may be made of a conductive material filled in a vertical through hole, and is configured to electrically connect the first connection pad and the second connection pad. The vertical through hole is a through hole that is formed through etching and that passes through the first wafer and partially passes through the second wafer to an upper surface and/or a sidewall of the second connection pad. The first connection pad is located in the vertical through hole. Etching is not performed on the first dielectric layer located below the first connection pad. In other words, the vertical through hole may expose an upper surface of the first wafer and the upper surface and the sidewall of the second connection pad. In this way, the contact plug in the vertical through hole may be in contact with both the first connection pad and the second connection pad, to implement an electrical connection between the first connection pad and the second connection pad. The contact plug is used as a signal transmission path between the first connection pad and the second connection pad. This path is relatively short. Therefore, a signal delay is reduced. In addition, the vertical through hole is formed by using an etching process, and passes through a sidewall of the first connection pad to the second connection pad. The contact plug may be in contact with the second connection pad from a periphery of the first connection pad, to implement a reliable connection between the contact plug and the second connection pad by using a simple process. In addition, in this embodiment of this application, only one metal plug exists, and therefore, a distance between two metal plugs does not need to be considered. Therefore, a horizontal dimension may be reduced to some extent, to reduce a device size and improve device integration.

To more clearly understand specific implementations of this application, the following describes the semiconductor device provided in this application in detail with reference to the accompanying drawings.

FIG. 3 is a schematic diagram of a structure of a semiconductor device according to an embodiment of this application. The semiconductor device may include a first wafer 300, a second wafer 400, and a contact plug 360 for implementing a vertical interconnection between the first wafer 300 and the second wafer 400. The first wafer 300 may include a first substrate 310, a first dielectric layer 320 on the first substrate 310, and a first connection pad 330 in the first dielectric layer 320. The second wafer 400 may include a second substrate 410, a second dielectric layer 420 on the second substrate 410, and a second connection pad 430 in the second dielectric layer 420.

The first substrate 310 and the second substrate 410 may be semiconductor substrates, for example, Si substrates, Ge substrates, SiGe substrates, SOI (Silicon On Insulator), or GOI (Germanium On Insulator). In other embodiments, the first substrate 310 and the second substrate 410 may alternatively be substrates including a semiconductor with another element or a semiconductor with another compound, for example, GaAs, InP, or SiC; or may be laminated structures, for example, Si/SiGe; or may be other epitaxial structures, for example, SGOI (germanium silicon on insulator). The first substrate 310 and the second substrate 410 may be made of the same material, or may be made of different materials. In this embodiment, the first substrate 310 and the second substrate 410 may be both silicon substrates.

All processes before bonding may be completed on the first substrate 310 and the second substrate 410. For example, a device structure and an interconnection structure of electrically connected device structures are formed on the first substrate 310 and the second substrate 410. The device structure is covered by an inter-layer dielectric layer. The inter-layer dielectric layer may be made of silicon oxide. The interconnection structure is formed in a dielectric material. The device structure may be a MOS device, a storage device, and/or another passive device. The interconnection structure may be a multi-layer structure. The interconnection structure may include a contact plug, a via, or a connection layer. The connection layer may be located at a top layer of the interconnection structure. As a lead-out structure of the interconnection structure, the connection layer may include a plurality of connection pads. The interconnection structure may be made of a metal material, for example, tungsten, aluminum, or copper. In the diagram of this embodiment of this application, to merely simplify the accompanying drawing, only the connection layer at the top layer is shown. It may be understood that this is merely an example. In different designs and applications, an interconnection structure including a required quantity of layers may be formed according to a requirement.

The same device structure or different device structures may be formed on the first substrate 310 and the second substrate 410. For example, devices on the first substrate 310 and the second substrate 410 may be both DRAM devices, or both logic devices, or respectively two devices of a DRAM device and a logic device, or respectively two devices of a SRAM device and a logic device, or respectively two devices of a CIS and an ISP.

The same interconnection structure or different interconnection structures may be formed on the first substrate 310 and the second substrate 410. Connection pads in the interconnection structures on the first substrate 310 and the second substrate 410 may have the same structure or different structures. For ease of differentiation, in this embodiment of this application, the first connection pad 330 in the interconnection structure on the first substrate 310 and the second connection pad 430 in the interconnection structure on the second substrate 410 are used as examples to describe interconnection structures between different wafers.

The first connection pad 330 is a connection pad in the interconnection structure of the first wafer 300 before the bonding, and may be a top metal layer (top metal) in the first wafer 300. A material of the first connection pad 330 may be metal copper. The first connection pad 330 may be covered by the first dielectric layer 320, to implement isolation between different first connection pads 330. The first dielectric layer 320 may be a silicon oxide layer, or may be a stacked structure, for example, may include a silicon nitride layer and a silicon oxide layer on the silicon nitride layer.

Similarly, the second connection pad 430 is a connection pad in the interconnection structure of the second wafer 400 before the bonding, and may be a top metal layer in the second wafer 400. A material of the second connection pad 430 may be metal copper. The second connection pad 430 may be covered by the second dielectric layer 420, to implement isolation between different second connection pads 430. The second dielectric layer 420 may be a silicon oxide layer, or may be a stacked structure, for example, may include a silicon nitride layer and a silicon oxide layer on the silicon nitride layer.

For ease of description, a surface on which a device structure is formed on the first substrate 310 is used as a front surface of the first wafer 300, and a surface opposite to the surface on which a device is formed on the first substrate 310 is used as a back surface of the first wafer 300; and a surface on which a device structure is formed on the second substrate 410 is used as a front surface of the second wafer 400, and a surface opposite to the surface on which a device is formed on the second substrate 410 is used as a back surface of the second wafer 400.

In this embodiment of this application, the first wafer 300 may be bonded to the second wafer 400. Actually, the first wafer 300 and the second wafer 400 may be two wafers in a plurality of bonded wafers. The front surface of the first wafer 300 may be opposite to and bonded to the front surface of the second wafer 400. The front surface of the first wafer 300 may alternatively be opposite to and bonded to the back surface of the second wafer 400. The back surface of the first wafer 300 may alternatively be opposite to and bonded to the front surface of the second wafer 400. The back surface of the first wafer 300 may alternatively be opposite to and bonded to the back surface of the second wafer 400. A surface used for bonding the first wafer 300 and the second wafer 400 is a bonding surface. A material layer used for bonding may be formed on the bonding surface. The bonding material layer may be an adhesive layer with a dielectric material, for example, silicon oxide or silicon nitride, to implement bonding between the two wafers by using molecular forces at the adhesive layer.

It should be noted that, in this embodiment of this application, "upper" and "lower" are relative to each other, and are related to a bonding manner of the first wafer 300 and the second wafer. Specifically, the first wafer 300 may be used as an upper wafer, and the second wafer 400 may be used as a lower wafer. When the front surface of the first wafer 300 is used as a bonding surface, the first wafer 300 is reversed, and original "upper" is changed to "lower". When the back surface of the first wafer 300 is used as a bonding surface, the first wafer 300 is not reversed, and original "upper" is still "upper". Similarly, when the front surface of the second wafer 400 is used as a bonding surface, the second wafer 400 is not reversed, and original "upper" is still "upper". When the back surface of the second wafer 400 is used as a bonding surface, the second wafer is reversed, and original "upper" is changed to "lower". In addition, descriptions such as upper, lower, left, right, front, back, top, and bottom are merely intended to facilitate indication of a relative position and/or a relative direction between devices, and are not intended to imply any specific fixed direction.

After the first wafer 300 is bonded to the second wafer 400, dielectric layer bonding is performed on the two wafers, and an electrical connection is not implemented between the first connection pad 330 in the first wafer 300 and the second connection pad 430 in the second wafer 400. Therefore, a connection between the first wafer 300 and the second wafer 400 needs to be implemented by using a vertical through hole 359. In this embodiment of this application, the first wafer 300 may be used as an upper wafer in the bonding structure. Etching is performed from the upper surface of the first wafer 300, to form the vertical through hole 359. It may be understood that, when the back surface of the first wafer 300 is used as a bonding surface 3001, etching may be performed from the front surface of the first wafer 300; or when the front surface of the first wafer 300 is used as a bonding surface 3001, etching may be performed from the back surface of the first wafer 300.

Currently, etching may be performed from the upper surface of the first wafer by using a TSV technology, to form two through silicon vias respectively passing through the first connection pad and the second connection pad. Then, a metal material is filled in the through silicon vias to form contact plugs. Afterwards, redistribution is performed on the upper surface of the first wafer, to establish a connection between the two contact plugs. However, in this connection manner, a path between the first connection pad and the second connection pad is relatively long, a size of each contact plug is limited by an etching process and cannot be reduced without limitation, and a distance between the contact plugs is also limited. Therefore, a plane area occupied by two three-dimensional interconnection structures in this process is relatively large. In addition, because the contact plug is in contact with the first connection pad or the second connection pad, sizes of the first connection pad and the second connection pad are also limited by the etching process, and match sizes of the contact plugs. Therefore, the sizes of the first connection pad and the second connection pad are relatively large. In addition, the distance between the first connection pad and the second connection pad corresponds to a horizontal distance between the contact plugs. The minimum distance between the first connection pad and the second connection pad is also limited. Therefore, a distribution design is also limited.

To resolve the foregoing problem, in this embodiment of this application, etching may be performed from the upper surface of the first wafer 300. The first connection pad 330 is used as a blocking layer to form the vertical through hole 359. This vertical through hole 359 exposes the upper surface of the first connection pad 330 and the upper surface and/or the sidewall of the second connection pad 430. The first connection pad 330 may protect the first dielectric layer and the second dielectric layer below the first connection pad 330 from being etched. In this case, after metal is filled in the vertical through hole 359, the formed contact plug 360 is in contact with the upper surface of the first connection pad 330, and also in contact with the upper surface and/or the sidewall of the second connection pad 430. In other words, the formed contact plug 360 is in contact with both the first connection pad 330 and the second connection pad 430, to form a connection between the first connection pad 330 and the second connection pad 430. The contact plug 360 may enclose the first connection pad 330 on at least one side. A requirement for a plane dimension of the first connection pad 330 is not high. Therefore, a plane area of a device may be further reduced.

The vertical through hole 359 may be a through hole with uneven sizes from top to bottom. Specifically, the vertical through hole 359 may pass through the first wafer to the upper surface of the first connection pad 330, to expose the upper surface of the first connection pad 330. The vertical through hole 359 may further pass through the first wafer and the second wafer to the second connection pad 430 along the sidewall of the first connection pad 330, to expose the upper surface and/or the sidewall of the second connection pad 430. In other words, the through hole above the first connection pad 330 may have a relatively large size, and the through hole between the first connection pad 330 and the second connection pad 430 may have a relatively small size.

Specifically, the vertical through hole 359 may expose the entire upper surface of the first connection pad 330, or may expose a part of the upper surface of the first connection pad 330. The vertical through hole 359 may expose the sidewall on one or more sides of the first connection pad 330, or may not expose the sidewall of the first connection pad 330. In this case, the sidewall of the first connection pad 330 is covered by a part of the first dielectric layer, to provide protection for the first connection pad 330. The vertical through hole 359 may expose the entire upper surface of the second connection pad 430, or may expose a part of the upper surface of the second connection pad 430. The vertical through hole 359 may expose the sidewall on one or more sides of the second connection pad 430, or may not expose the sidewall of the second connection pad 430. In this case, the sidewall of the second connection pad 430 is covered by the second dielectric layer.

FIG. 4 is a schematic diagram of shapes of a first connection pad and a second connection pad according to an embodiment of this application. The first connection pad 330 may be polygonal or circular, and the second connection pad 430 may be polygonal or circular. The first connection pad 330 and the second connection pad 430 may have the same shape or different shapes. Certainly, a horizontal distance between the first connection pad 330 and the second connection pad 430 is relatively short. The first connection pad 330 and the second connection pad 430 may have overlapping projections in a vertical direction, or have no overlapping projection in a vertical direction. A polygon may be, for example, a strip. A circle may be, for example, a perfect circle or an oval. For example, the first connection pad 330 is a strip, and the second connection pad 430 is also a strip. The first connection pad 330 and the second connection pad 430 may have the same size or different sizes.

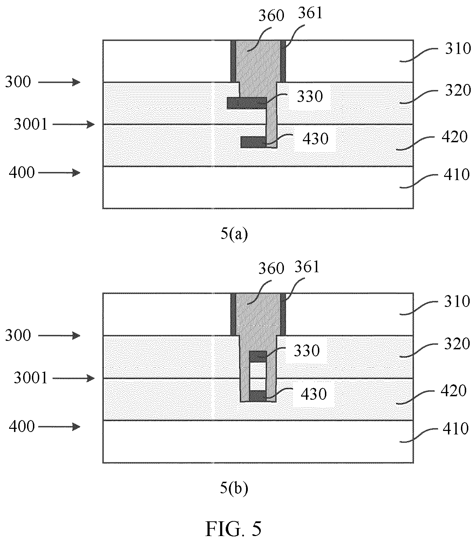

In a possible implementation, FIG. 5 is a schematic diagram of a structure of a semiconductor device according to an embodiment of this application. The second connection pad 430 and the first connection pad 330 may be disposed opposite to each other in a vertical direction. In other words, there is an overlapping region between the first connection pad 330 and the first connection pad 330 in a direction perpendicular to the bonding surface 3001, and the sidewall of the second connection pad 430 is flush with the sidewall of the first connection pad 330 on at least one side. In this way, the vertical through hole 359 may expose the sidewalls of the second connection pad 430 and the first connection pad 330, and the exposed sidewalls of the second connection pad 430 and the first connection pad 330 are flush with each other. In this way, the contact plug 360 in the vertical through hole 359 is separately connected to the sidewall of the second connection pad 430 and the sidewall of the first connection pad 330, to electrically connect the second connection pad 430 and the first connection pad 330. Specifically, as shown in FIG. 5(a), the second connection pad 430 may be aligned with the first connection pad 330 on one side, the sidewall on one side of the first connection pad 330 exceeds the sidewall of the second connection pad 430 in the horizontal direction, and the contact plug 360 may be in contact with the upper surface and the sidewall on one side of the first connection pad 330 and the sidewall on one side of the second connection pad 430. As shown in FIG. 5(b), the second connection pad 430 may be aligned with the first connection pad 330 on a plurality of sides, and the contact plug 360 may be in contact with the upper surface and the sidewall on a plurality of sides of the first connection pad 330, and the sidewall on a plurality of sides of the second connection pad 430.

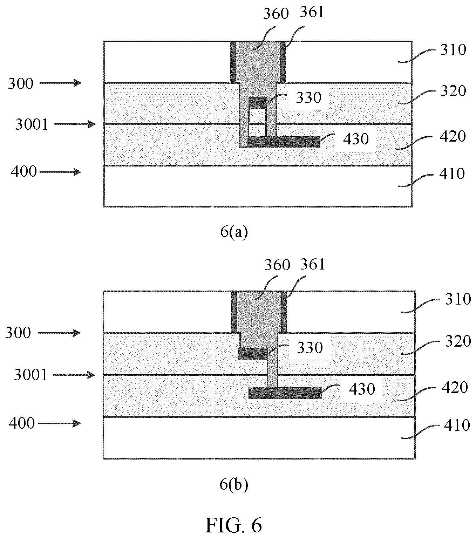

In another possible implementation, FIG. 6 is a schematic diagram of a structure of another semiconductor device according to an embodiment of this application. The second connection pad 430 may be disposed opposite to the first connection pad 330 in the vertical direction. The sidewall on at least one side of the second connection pad 430 exceeds the sidewall of the first connection pad 330 in the horizontal direction. In this case, the formed vertical through hole 359 exposes at least a part of a surface that is on a side of the second connection pad 430 and that exceeds the sidewall of the first connection pad 330 in the horizontal direction, that is, exposes the upper surface adjacent to the sidewall that is of the second connection pad 430 and that exceeds the sidewall of the first connection pad 330 in the horizontal direction, and exposes the sidewall and the upper surface adjacent to the sidewall that is of the second connection pad 430 and that exceeds the sidewall of the first connection pad 330 in the horizontal direction. In this way, the contact plug 360 filled in the vertical through hole 359 is at least in contact with the upper surface of the second connection pad 430. In addition, the vertical through hole 359 may further expose the upper surface of the first connection pad 330, so that the contact plug 360 can connect the first connection pad 330 and the second connection pad 430.

Specifically, the sidewall on one side of the second connection pad 430 may exceed the first connection pad 330 in the horizontal direction. As shown in FIG. 6(a), the sidewall on one side of the second connection pad 430 may be aligned with the first connection pad 330, and the sidewall on another side of the second connection pad 430 exceeds the sidewall of the first connection pad 330 in the horizontal direction. The contact plug 360 may be in contact with the upper surface and the sidewall on a plurality of sides of the first connection pad 330, and the sidewall on one side and the upper surface on another side of the second connection pad 430. As shown in FIG. 6(b), the sidewall on one side of the second connection pad 430 may exceed the first connection pad 330 in the horizontal direction, and the sidewall on another side of the second connection pad 430 is concave relative to the first connection pad 330. The contact plug 360 may be in contact with the upper surface and the sidewall on one side of the first connection pad 330, and the upper surface on one side that is of the second connection pad 430 and that exceeds the sidewall of the first connection pad 330 in the horizontal direction.

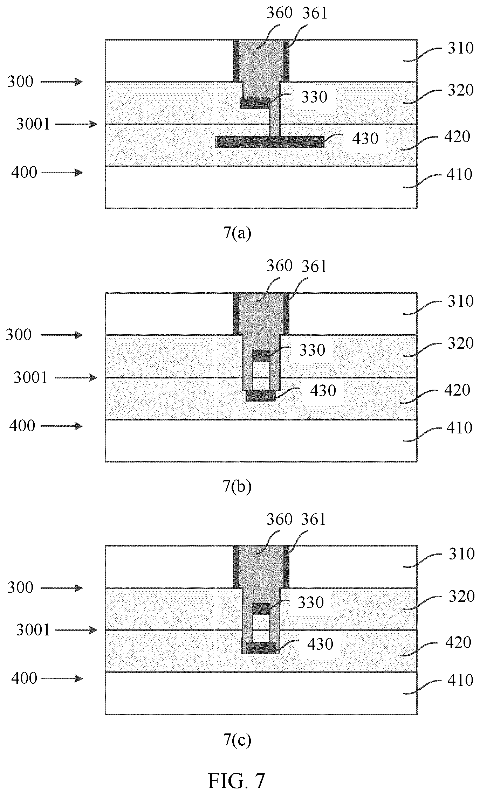

Specifically, the sidewall on a plurality of sides of the second connection pad 430 may exceed the first connection pad 330 in the horizontal direction. FIG. 7 is a schematic diagram of a structure of still another semiconductor device according to an embodiment of this application. As shown in FIG. 7(a), the contact plug 360 may be in contact with the upper surface and the sidewall on one side of the first connection pad 330, and the upper surface that is on a side of the second connection pad 430 and that exceeds the sidewall of the first connection pad 330. As shown in FIG. 7(b) and FIG. 3, the contact plug 360 may be in contact with the upper surface and the sidewall on a plurality of sides of the first connection pad 330 and the upper surface of the second connection pad 430. As shown in FIG. 7(c), the contact plug 360 may be in contact with the upper surface and the sidewall on a plurality of sides of the first connection pad 330, and the upper surface and the sidewall on a plurality of sides of the second connection pad 430.

In the foregoing examples, a part of the first dielectric layer is reserved between the contact plug 360 and the first connection pad 330, to provide protection for the first connection pad 330 in an etching process.

In conclusion, in this embodiment of this application, the contact plug 360 may connect the first connection pad 330 and the second connection pad 430 from a plurality of sides of the first connection pad 330, to improve to some extent a contact area between the contact plug 360 and the second connection pad 430 and improve contact reliability between the contact plug 360 and the second connection pad 430.

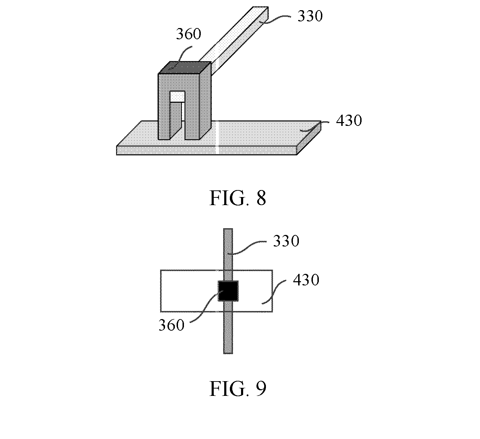

FIG. 8 is a schematic diagram of a structure of a three-dimensional interconnection structure according to an embodiment of this application. FIG. 9 is a top view of a three-dimensional interconnection structure according to an embodiment of this application. The contact plug 360 forms an arch structure, to implement a connection between the first connection pad 330 and the second connection pad 430. The contact plug 360 is formed on left and right sides of the first connection pad 330. A width between the left side and the right side of the first connection pad 330 may be relatively small. In addition, there may be an overlapping region between the first connection pad 330 and the second connection pad 430. There is no need to set a relatively large distance, to reduce a distribution area to some extent.

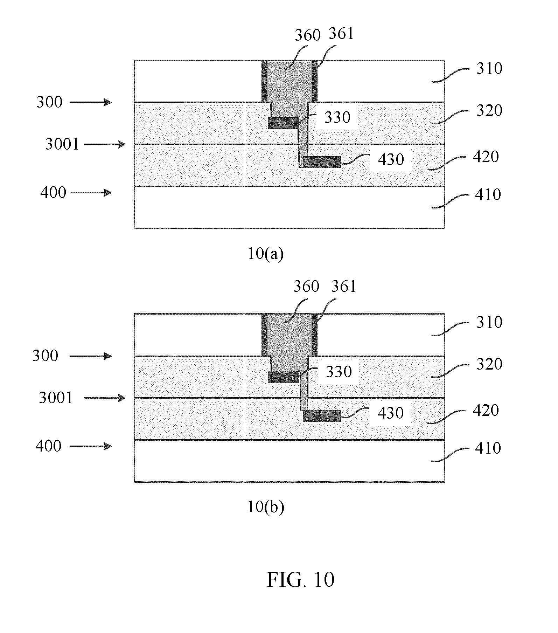

In still another possible implementation, FIG. 10 is a schematic diagram of a structure of yet another semiconductor device according to an embodiment of this application. The second connection pad 430 and the first connection pad 330 are disposed in a staggered manner in the vertical direction. In other words, there is no overlapping region between the second connection pad 430 and the first connection pad 330 in a direction perpendicular to the bonding surface 3001. Therefore, a size of the top opening of the vertical through hole 359 is greater than or equal to the horizontal distance between the second connection pad 430 and the first connection pad 330. Specifically, as shown in FIG. 10(a), when the size of the top opening of the vertical through hole 359 is equal to the horizontal distance between the second connection pad 430 and the first connection pad 330, the vertical through hole 359 may expose the opposite sidewalls of the first connection pad 330 and the second connection pad 430, that is, expose the sidewall that is of the first connection pad 330 and that faces the second connection pad 430, and expose the sidewall that is of the second connection pad 430 and that faces the first connection pad 330. In this case, the vertical through hole 359 has even horizontal sizes at different depths, so that the metal plug 360 in the vertical through hole 359 can connect the exposed sidewalls of the first connection pad 330 and the second connection pad 430, to implement an electrical connection between the first connection pad 330 and the second connection pad 430. The size of the top opening of the vertical through hole 359 may be greater than the horizontal sizes of the second connection pad 430 and the first connection pad 330. In addition to the opposite sidewalls of the first connection pad 330 and the second connection pad 430, the vertical through hole 359 may further expose a part of the upper surface of the first connection pad 330 and/or a part of the upper surface of the second connection pad 430. As shown in FIG. 10(b), to improve contact reliability, actually, when the vertical through hole 359 exposes the upper surface of the first connection pad 330, a part of the first dielectric layer is retained on the sidewall of the first connection pad 330, to provide protection for the first connection pad 330.

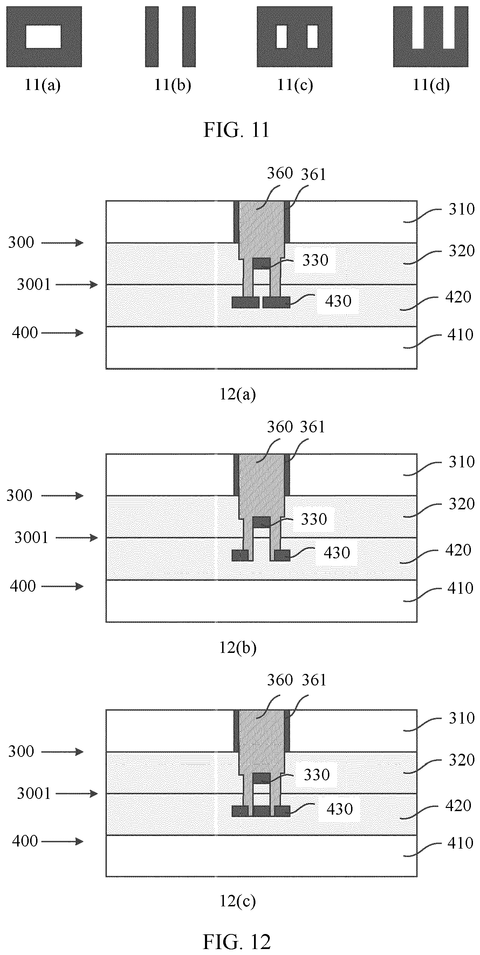

FIG. 11 is a schematic diagram of other shapes of a first connection pad and a second connection pad according to an embodiment of this application. A shape of the first connection pad 330 may be a slit shape or a comb tooth shape. In this case, a shape of the second connection pad 430 may be a polygon, a circle, a slit shape, or a comb tooth shape. Certainly, when the shape of the first connection pad 330 is a polygon or a circle, the shape of the second connection pad 430 may be a slit shape or a comb tooth shape. The slit shape may be a single slit shape or a multi-slit shape. The slit shape may include a single slit shape with reference to FIG. 11(a), or a multi-slit shape with reference to FIG. 11(b) and FIG. 11(c), or a comb tooth shape with reference to FIG. 11(d). A quantity of comb teeth in the comb tooth shape may be determined according to an actual case.

When the shapes of the first connection pad 330 and the second connection pad 430 are the slit shape or the comb tooth shape, the slit shape or the comb tooth shape may be considered as a combination of a plurality of lines. For a connection manner of each line, refer to the foregoing connection manners of lines. In other words, the formed vertical through hole 359 may expose or may not expose a sidewall of a connection pad in the slit shape or the comb tooth shape, provided that the vertical through hole 359 can expose both a part of the upper surface of the first connection pad 330 and a part of the upper surface of the second connection pad 430, to implement contact between the contact plug 360 and each of the first connection pad 330 and the second connection pad 430.

FIG. 12 is a schematic diagram of a structure of still yet another semiconductor device according to an embodiment of this application. For example, the second connection pad 430 is in the single slit shape. In this case, as shown in FIG. 12(a), the contact plug 360 may be connected to the upper surface and the sidewall of the first connection pad 330 and the upper surface of the second connection pad 430. As shown in FIG. 12(b), the contact plug 360 may be connected to the upper surface and the sidewall of the first connection pad 330 and the upper surface and the sidewall of the second connection pad 430. For example, the second connection pad 430 is in a double slit shape. As shown in FIG. 12(c), the contact plug 360 may be connected to the upper surface and the sidewall of the first connection pad 330 and the sidewall of the second connection pad 430.

In other words, the vertical through hole 359 may be a through hole passing through the upper surface of the first wafer 300 to the upper surface of the first connection pad 330, and passing through the periphery of the first connection pad 330 to the upper surface of the second connection pad 430. The through hole exposes the upper surface of the first connection pad 330 and the upper surface and/or the sidewall of the second connection pad 430, to form the vertical through hole 359 with a relatively large size at an upper part and a relatively small size at a lower part.

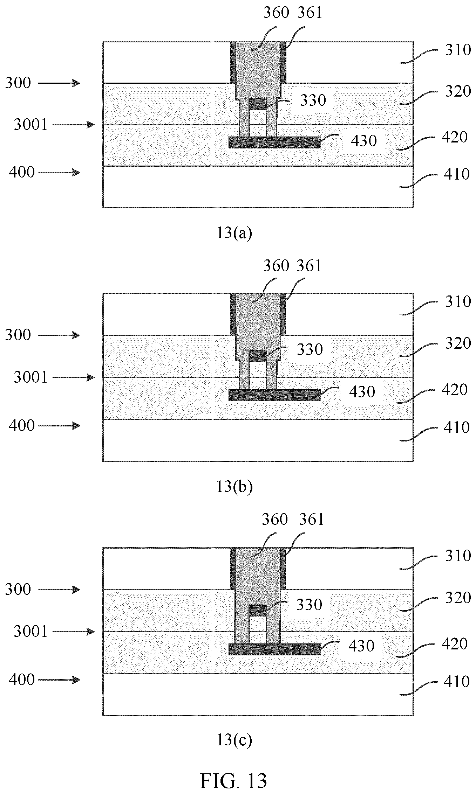

In this embodiment of this application, due to an impact of the etching process, the vertical through hole 359 may have different sizes at a part above a plane and a part below the plane. FIG. 13 is a schematic diagram of a structure of a further semiconductor device according to an embodiment of this application. Specifically, as shown in FIG. 3, a size of the vertical through hole 359 in the first substrate 310 may be different from a size of the vertical through hole 359 in the first dielectric layer 320. As shown in FIG. 13(a) and FIG. 13(c), a size of the vertical through hole 359 above the upper surface of the first connection pad 330 may be different from a size of the vertical through hole 359 below the upper surface of the first connection pad 330. As shown in FIG. 13(b), a size of the vertical through hole 359 above the lower surface of the first connection pad 330 may be different from a size of the vertical through hole 359 below the lower surface of the first connection pad 330. As shown in FIG. 12(b), a size of the vertical through hole 359 above the upper surface of the second connection pad 430 may be different from a size of the vertical through hole 359 below the upper surface of the second connection pad 430.

It may be understood that the foregoing accompanying drawings are merely example descriptions, and are not intended to include all cases provided in the embodiments of this application. For brief description, examples are not given one by one herein for illustration. A person skilled in the art may set another structure based on the foregoing descriptions. This shall fall within the protection scope of this application.

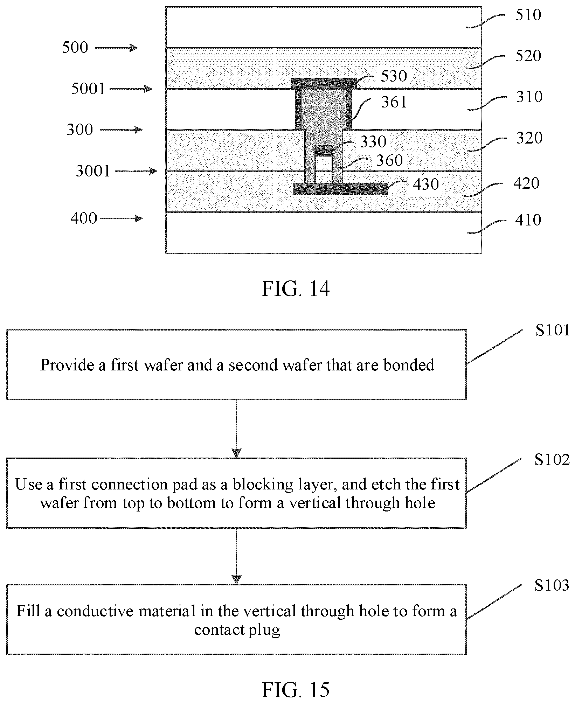

The semiconductor device provided in this embodiment of this application may further include a third wafer. FIG. 14 is a schematic diagram of a structure of still further semiconductor device according to an embodiment of this application. The first wafer 300, the second wafer 400, and the third wafer 500 form three stacked layers. The third wafer 500 may include a third substrate 510. A third dielectric layer 520 may be formed on the third substrate 510. The third dielectric layer 520 may have a third connection pad 530. The third wafer 500 may be disposed on the first wafer 300. An electrical connection is implemented between the third connection pad 530 in the third wafer 500 and the contact plug 360 through bonding between the first wafer 300 and the third wafer 500. Alternatively, the third connection pad 530 and the contact plug 360 may be connected (not shown in the figure) by using another contact plug formed by using a manufacturing process similar to the contact plug 360, after dielectric layer bonding is performed on the first wafer 300 and the third wafer 500. For a bonding surface 5001 between the first wafer 300 and the third wafer 500, refer to FIG. 14.

The embodiments of this application provide the semiconductor device. The semiconductor device includes the first wafer, the second wafer, and the contact plug. The first wafer may include the first dielectric layer. The first dielectric layer has the first connection pad. The second wafer is bonded to the first wafer. The second wafer includes the second dielectric layer. The second dielectric layer has the second connection pad. The contact plug is made of a conductive material filled in the vertical through hole, and is configured to electrically connect the first connection pad and the second connection pad. The vertical through hole is a through hole that is formed through etching and that passes through the first wafer and partially passes through the second wafer to the upper surface and/or the sidewall of the second connection pad. The first connection pad is located in the vertical through hole. Etching is not performed on the first dielectric layer located below the first connection pad. In this way, the contact plug in the vertical through hole may be in contact with the upper surface of the first connection pad and the upper surface and/or the sidewall of the second connection pad, to implement an electrical connection between the first connection pad and the second connection pad and implement a vertical interconnection between the first wafer and the second wafer. The contact plug is used as a signal transmission path between the first connection pad and the second connection pad. This path is relatively short. Therefore, a signal delay is reduced. In addition, the vertical through hole is formed by using an etching process, and passes through the sidewall of the first connection pad to the second connection pad. The contact plug may be in contact with the second connection pad from the periphery of the first connection pad, to implement a reliable connection between the contact plug and the second connection pad by using a simple process. In addition, in this embodiment of this application, only one metal plug exists, and therefore, a distance between two metal plugs does not need to be considered. Therefore, a horizontal dimension may be reduced to some extent, to reduce a device size and improve device integration.

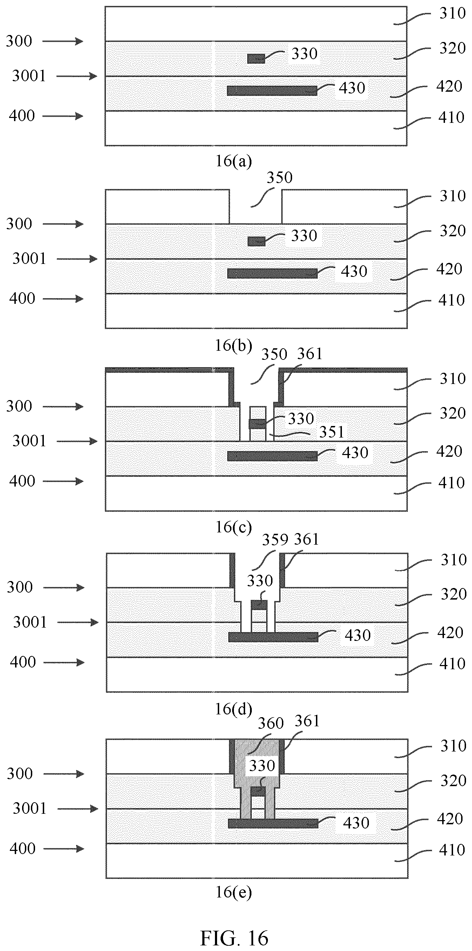

Based on the semiconductor device provided in the foregoing embodiments, the embodiments of this application further provide a manufacturing method of a semiconductor device. FIG. 15 is a flowchart of a manufacturing method of a semiconductor device according to an embodiment of this application. FIG. 16 to FIG. 20 are schematic diagrams of a semiconductor device in a manufacturing process of the semiconductor device according to an embodiment of this application. The method may include the following steps:

S101: Provide a first wafer 300 and a second wafer 400 that are bonded, with reference to FIG. 16(a), FIG. 17(a), FIG. 18(a), FIG. 19(a), and FIG. 20(a).

In this embodiment of this application, the first wafer 300 may include a first substrate 310, a first dielectric layer 320 on the first substrate 310, and a first connection pad 330 in the first dielectric layer 320. The second wafer 400 may include a second substrate 410, a second dielectric layer 420 on the second substrate 410, and a second connection pad 430 in the second dielectric layer 420. The same device structure or different device structures may be formed on the first substrate 310 and the second substrate 410. For example, devices on the first substrate 310 and the second substrate 410 may be both DRAM devices, or both logic devices, or respectively two devices of a DRAM device and a logic device, or respectively two devices of a SRAM device and a logic device, or respectively two devices of a CIS and an ISP.

The first connection pad 330 is a connection pad in the interconnection structure of the first wafer 300 before the bonding, and may be a top metal layer (top metal) in the first wafer 300. A material of the first connection pad 330 may be metal copper. The first connection pad 330 may be covered by the first dielectric layer 320, to implement isolation between different first connection pads 330. The first dielectric layer 320 may be a silicon oxide layer, or may be a stacked structure, for example, may include a silicon nitride layer and a silicon oxide layer on the silicon nitride layer.

Similarly, the second connection pad 430 is a connection pad in the interconnection structure of the second wafer 400 before the bonding, and may be a top metal layer in the second wafer 400. A material of the second connection pad 430 may be metal copper. The second connection pad 430 may be covered by the second dielectric layer 420, to implement isolation between different second connection pads 430. The second dielectric layer 420 may be a silicon oxide layer, or may be a stacked structure, for example, may include a silicon nitride layer and a silicon oxide layer on the silicon nitride layer.

For ease of description, a surface on which a device structure is formed on the first substrate 310 is used as a front surface of the first wafer 300, and a surface opposite to the surface on which a device is formed on the first substrate 310 is used as a back surface of the first wafer 300; and a surface on which a device structure is formed on the second substrate 410 is used as a front surface of the second wafer 400, and a surface opposite to the surface on which a device is formed on the second substrate 410 is used as a back surface of the second wafer 400.

In this embodiment of this application, the first wafer 300 may be bonded to the second wafer 400. During implementation, the first wafer 300 and the second wafer 400 may be two wafers in a plurality of bonded wafers. The front surface of the first wafer 300 may be opposite to and bonded to the front surface of the second wafer 400. The front surface of the first wafer 300 may alternatively be opposite to and bonded to the back surface of the second wafer 400. The back surface of the first wafer 300 may alternatively be opposite to and bonded to the front surface of the second wafer 400. The back surface of the first wafer 300 may alternatively be opposite to and bonded to the back surface of the second wafer 400. A material layer used for bonding may be formed on a surface used for bonding the first wafer 300 and the second wafer 400. The bonding material layer may be an adhesive layer with a dielectric material, for example, silicon oxide or silicon nitride, to implement bonding between the two wafers by using molecular forces at the adhesive layer.

After the first wafer 300 is bonded to the second wafer 400, dielectric layer bonding is performed on the two wafers, and a vertical interconnection is not implemented between the first connection pad 330 in the first wafer 300 and the second connection pad 430 in the second wafer 400. Therefore, a connection between the first wafer 300 and the second wafer 400 needs to be implemented.

S102: Use the first connection pad 330 as a blocking layer, and etch the first wafer 300 from top to bottom to form a vertical through hole 359. The vertical through hole 359 passes through the first wafer to an upper surface of the first connection pad 330, passes through the first wafer and the second wafer to the second connection pad 430 along the sidewall of the first connection pad 330, and exposes an upper surface and a sidewall of the second connection pad 430.

In this embodiment of this application, the first wafer 300 may be used as an upper wafer in the bonding structure. Etching is performed from the upper surface of the first wafer 300, to form the vertical through hole 359. It may be understood that, when the back surface of the first wafer 300 is used as a bonding surface 3001, etching may be performed from the front surface of the first wafer 300; or when the front surface of the first wafer 300 is used as a bonding surface 3001, etching may be performed from the back surface of the first wafer 300.

Specifically, the vertical through hole 359 may expose the entire upper surface of the first connection pad 330, or may expose a part of the upper surface of the first connection pad 330. The vertical through hole 359 may expose the sidewall on one or more sides of the first connection pad 330, or may not expose the sidewall of the first connection pad 330. In this case, the sidewall of the first connection pad 330 is covered by a part of the first dielectric layer, to provide protection for the first connection pad 330. The vertical through hole 359 may expose the entire upper surface of the second connection pad 430, or may expose a part of the upper surface of the second connection pad 430. The vertical through hole 359 may expose the sidewall on one or more sides of the second connection pad 430, or may not expose the sidewall of the second connection pad 430. In this case, the sidewall of the second connection pad 430 is covered by the second dielectric layer.

The following uses bonding between the front surface of the first wafer 300 and the second wafer 400 as an example for description. There are a plurality of manners of forming the vertical through hole 359 through etching. Different etching manners may be used for different connection pads and vertical through holes 359 with different structures. The following provides an example for description.

In a possible implementation, the second connection pad 430 is disposed opposite to the first connection pad 330 in a vertical direction. The second connection pad 430 is located below the first connection pad 330. The sidewall of the second connection pad 430 may be flush with the sidewall of the first connection pad 330, or the sidewall of the second connection pad 430 exceeds the sidewall of the first connection pad 330 in the horizontal direction. A manner of forming the vertical through hole 359 may be specifically as follows: first performing etching from the upper surface of the first wafer to obtain a first opening, where the first opening is located above the first connection pad 330, and a sidewall on at least one side of the first opening may exceed the sidewall of the first connection pad 330 in the horizontal direction. In this way, the first opening may be deepened, to expose the first connection pad 330. Etching is performed in a position in which a bottom of the first opening exceeds the sidewall of the first connection pad 330 in the horizontal direction. A second opening to the second connection pad 430 may be formed around the periphery of the first connection pad 330, to form the vertical through hole 359. When the opening to the second connection pad 430 is formed through etching, the first connection pad 330 may protect the first dielectric layer and the second dielectric layer below the first connection pad 330. Generally, a position of the second opening may be determined based on a position of the second connection pad 430 relative to the first connection pad 330. A direction in which the sidewall of the second connection pad 430 exceeds the sidewall of the first connection pad 330 in the horizontal direction may be consistent with a direction in which the sidewall of the second opening exceeds the sidewall of the first connection pad 330.

As shown in FIG. 16, the sidewall on a plurality of sides of the second connection pad 430 exceeds the sidewall of the first connection pad 330 in the horizontal direction. First, etching may be performed from the back surface of the first wafer 300, that is, etching may be performed from the back surface of the first substrate 310 to form the first opening 350. As shown in FIG. 16(b), the first opening 350 may be above the first connection pad 330, and the sidewall on a plurality of sides of the first opening 350 exceeds the sidewall of the first connection pad 330 in the horizontal direction. Etching of the first opening 350 may be stopped in a position of the lower surface of the first substrate 310, or etching may be further performed on a part of the first dielectric layer 320 (not shown in the figure) and stopped in the first dielectric layer 320. An insulation layer 361 is deposited to protect the sidewall of the first opening 350. As shown in FIG. 16(c), etching is performed on the bottom in the position in which the sidewall of the first opening 350 exceeds the sidewall of the first connection pad 330 in the horizontal direction (in this time of etching, the sidewall of the first connection pad 330 may be exposed, or a part of the first dielectric layer 320 may be reserved and the sidewall of the first connection pad 330 may be not exposed), to form a second opening 351 to the bonding surface 3001. Then, as shown in FIG. 16(d), the first connection pad 330 is used as a blocking layer, and the first opening 350 and the second opening 351 are both deepened, to remove the first dielectric layer 320 above the first connection pad 330 and the second dielectric layer 420 above the second connection pad 430, thereby forming the vertical through hole 359. The formed vertical through hole 359 exposes the upper surface of the first connection pad 330, and a part of the upper surface that is on a plurality of sides of the second connection pad 430 and that exceeds the sidewall of the first connection pad 330 in the horizontal direction. A part of the first dielectric layer 320 on the sidewall of the first connection pad 330 is reserved, to protect the first connection pad 330 and avoid damage or collapse caused due to etching performed on the first connection pad 330.

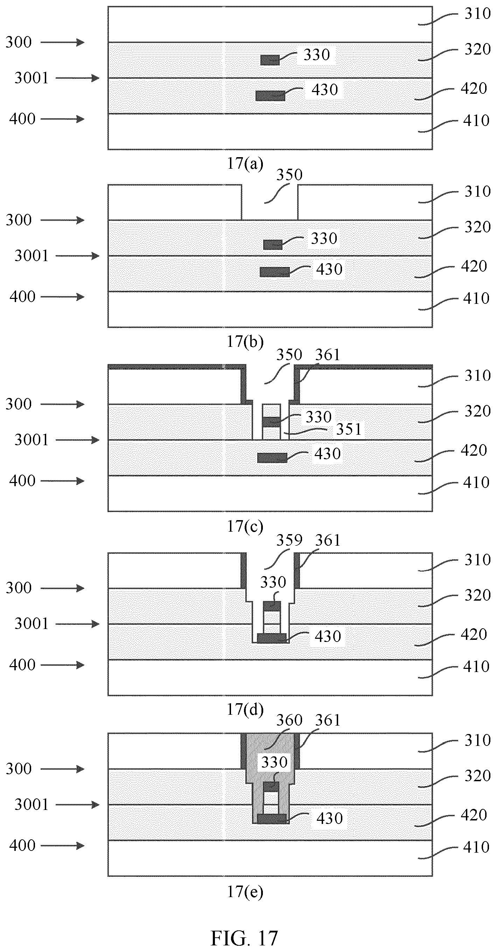

In addition, when a size of a part that is of the second connection pad 430 and that exceeds the sidewall of the first connection pad 330 is relatively small, the second dielectric layer on the sidewall of the second connection pad 430 may be removed through etching to expose the sidewall of the second connection pad 430. As shown in FIG. 17, etching is performed from the back surface of the first wafer 300. In other words, as shown in FIG. 17(b), etching is performed from a back surface of the first substrate 310 to form the first opening 350. Certainly, etching of the first opening 350 may be stopped in a position of a lower surface of the first substrate 310, or etching may be further performed on a part of the first dielectric layer 320 (not shown in the figure) and stopped in the first dielectric layer 320. As shown in FIG. 17(c), an insulation layer 361 is deposited to protect the sidewall of the first opening 350. As shown in FIG. 17(c), etching is performed on a bottom in a position in which the sidewall of the first opening 350 exceeds the sidewall of the first connection pad 330 in the horizontal direction to form a second opening 351 to the bonding surface 3001. Then, the first connection pad 330 is used as a blocking layer, and the first opening 350 and the second opening 351 are both deepened, so that the deepened second opening 351 is stopped at a lower surface of the second connection pad 430. In an etching process, the first connection pad 330 may protect the first dielectric layer and the second dielectric layer below the first connection pad 330, to form the vertical through hole 359. The vertical through hole 359 exposes the upper surface of the first connection pad 330, and a part of the upper surface and the sidewall that is on a plurality of sides of the second connection pad 430 and that exceeds the sidewall of the first connection pad 330.

In addition, when the second connection pad 430 is flush with the first connection pad 330, the dielectric layers on the sidewalls of the first connection pad 330 and the second connection pad 430 may be removed through etching, to expose the sidewalls of the first connection pad 330 and the second connection pad 430. For specific operation steps, refer to steps shown in FIG. 16. Details are not described herein again.

In another possible implementation, the second connection pad 430 is disposed opposite to the first connection pad 330 in the vertical direction. The second connection pad 430 is located below the first connection pad 330. In addition, the sidewall of the second connection pad 430 may be flush with the sidewall of the first connection pad 330, or the sidewall of the second connection pad 430 may exceed the sidewall of the first connection pad 330 in the horizontal direction. A third opening may be formed in the first wafer before bonding between wafers. The third opening is formed in the first dielectric layer around the first connection pad 330. In this way, an etching load after the bonding may be reduced. A manner of forming the vertical through hole may be specifically as follows: after the bonding between wafers, performing etching from the upper surface of the first wafer to form a first opening, where the first opening is located above the first connection pad 330, and the sidewall on at least one side of the first opening may exceed the sidewall of the first connection pad 330 in the horizontal direction. In this way, the first opening may be deepened to expose the first connection pad 330. In addition, the first opening may be connected to the third opening, and the third opening may be deepened. The deepened third opening may expose the second connection pad 430, to form the vertical through hole 359. When the opening to the second connection pad 430 is formed through etching, the first connection pad 330 may protect the first dielectric layer and the second dielectric layer below the first connection pad 330. Generally, a position of the third opening may be determined based on a position of the second connection pad 430 relative to the first connection pad 330. A direction in which the sidewall of the second connection pad 430 exceeds the sidewall of the first connection pad 330 in the horizontal direction may be consistent with a direction in which the third opening is disposed in the first dielectric layer.

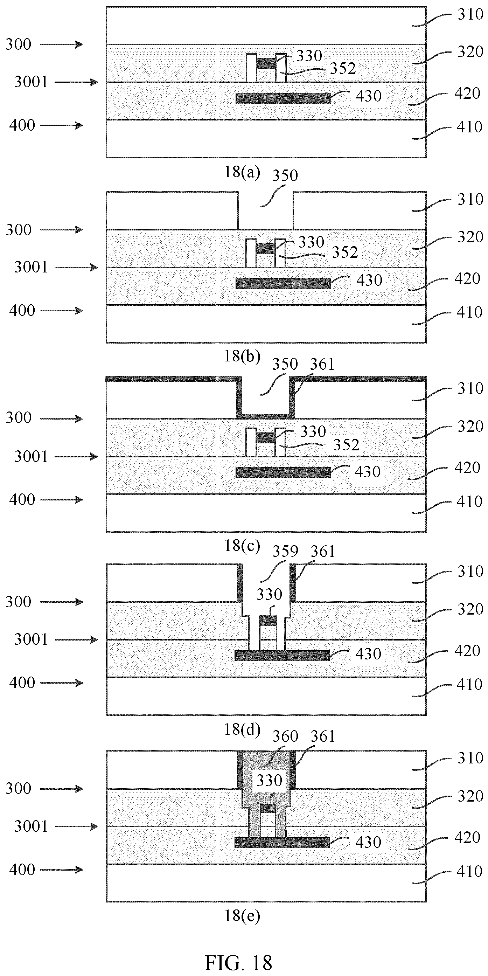

As shown in FIG. 18, the sidewall on a plurality of sides of the second connection pad 430 exceeds the sidewall of the first connection pad 330 in the horizontal direction. A third opening 352 may be formed in the first wafer 300. The third opening 352 is formed in the first dielectric layer 320 around the first connection pad 330. In other words, as shown in FIG. 18(a), before the bonding between the first wafer 300 and the second wafer 400, etching may be performed on the first dielectric layer 320, to form the third opening 352 around the first connection pad 330. In this case, as shown in FIG. 18(b), after the bonding between wafers, etching may be performed from the back surface of the first wafer 300, that is, etching may be performed from the back surface of the first substrate 310 to form the first opening 350. The first opening 350 may be above the first connection pad 330, and the sidewall on a plurality of sides of the first opening 350 exceeds the sidewall of the first connection pad 330 in the horizontal direction. Certainly, etching of the first opening 350 may be stopped in a position of the lower surface of the first substrate 310, or etching may be further performed on a part of the first dielectric layer 320 (not shown in the figure) and stopped in the first dielectric layer 320. As shown in FIG. 18(c), an insulation layer 361 is deposited to protect the sidewall of the first opening 350. As shown in FIG. 18(d), the first connection pad 330 is used as a blocking layer. The first opening 350 is deepened to connect the first opening 350 to the third opening 352. Then, etching is further performed to deepen the third opening 352. Therefore, the deepened first opening 350 exposes the upper surface of the first connection pad 330, and the deepened third opening 352 exposes the upper surface of the second connection pad 430 to form the vertical through hole 359.

In addition, when a size of a part that is of the second connection pad 430 and that exceeds the sidewall of the first connection pad 330 is relatively small, the second dielectric layer on the sidewall of the second connection pad 430 may be removed through etching to expose the sidewall of the second connection pad 430. Examples are not provided for description herein. When the second connection pad 430 is flush with the first connection pad 330, the dielectric layers on the sidewalls of the first connection pad 330 and the second connection pad 430 may be removed through etching, to expose the sidewalls of the first connection pad 330 and the second connection pad 430. For specific operation steps, refer to steps shown in FIG. 18. Details are not described herein again.

In still another possible implementation, the second connection pad 430 is disposed opposite to the first connection pad 330 in the vertical direction. The second connection pad 430 is located below the first connection pad 330. The sidewall of the second connection pad 430 may be flush with the sidewall of the first connection pad 330, or the sidewall of the second connection pad 430 may exceed the sidewall of the first connection pad 330 in the horizontal direction. A manner of forming the vertical through hole 359 may be specifically as follows: first performing etching from the upper surface of the first wafer to obtain a first opening, where the first opening is located above the first connection pad 330, and a sidewall on at least one side of the first opening may exceed the sidewall of the first connection pad 330 in the horizontal direction. In this way, the first opening may be deepened, to expose the first connection pad 330. The first opening is further deepened. In this case, the first connection pad 330 may protect the first dielectric layer and the second dielectric layer below the first connection pad 330. Etching is performed on the first dielectric layer and the second dielectric layer in a position in which the first opening exceeds the sidewall of the first connection pad 330 in the horizontal direction. The deepened first opening around the first connection pad 330 may pass through the second connection pad 430 around the first connection pad 330, to form the vertical through hole 359.

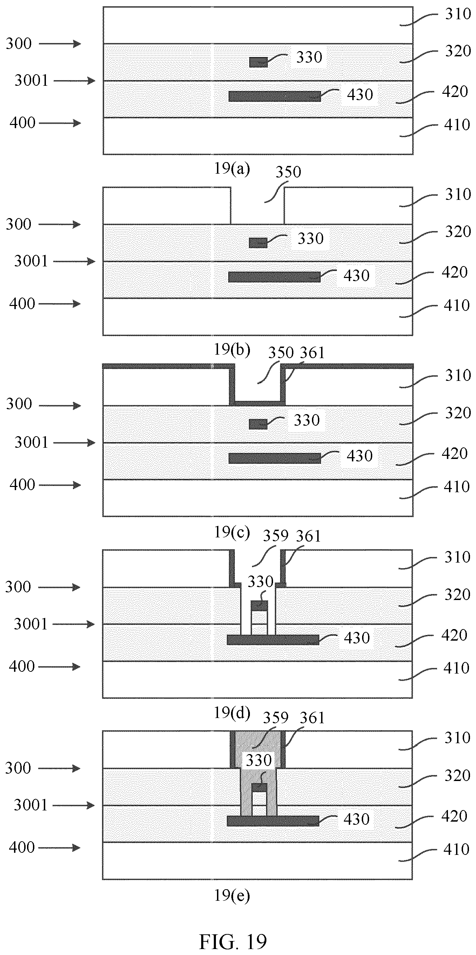

As shown in FIG. 19, the sidewall on a plurality of sides of the second connection pad 430 exceeds the sidewall of the first connection pad 330 in the horizontal direction. As shown in FIG. 19(b), etching is performed from the back surface of the first wafer 300, that is, etching is performed from the back surface of the first substrate 310, to form the first opening 350. The first opening 350 may be above the first connection pad 330, and the sidewall on a plurality of sides of the first opening 350 exceeds the sidewall of the first connection pad 330. Certainly, etching of the first opening 350 may be stopped in a position of the lower surface of the first substrate 310, or etching may be further performed on a part of the first dielectric layer 320 (not shown in the figure) and stopped in the first dielectric layer 320. As shown in FIG. 19(c), an insulation layer 361 is deposited to protect the sidewall of the first opening 350. As shown in FIG. 19(d), the first opening 350 is deepened. The second connection pad 430 is used as an etching stop layer. In an etching process, the first connection pad 330 provides protection for the first dielectric layer and the second dielectric layer below the first connection pad 330 until the upper surface of the second connection pad 430 is exposed. In this case, the upper surface of the first connection pad 330 is also exposed in the deepened first opening 350 to form the vertical through hole 359.

In further another possible implementation, the second connection pad 430 is disposed opposite to the first connection pad 330 in the vertical direction. The second connection pad 430 is located below the first connection pad 330. The sidewall of the second connection pad 430 may be flush with the sidewall of the first connection pad 330, or the sidewall of the second connection pad 430 may exceed the sidewall of the first connection pad 330 in the horizontal direction. A manner of forming the vertical through hole 359 may be specifically as follows: performing etching from the upper surface of the first wafer to form a fourth opening. A sidewall on at least one side of the fourth opening exceeds the sidewall of the first connection pad 330. Then, the first connection pad 330 may be used as a blocking layer. Etching is performed on a part above the first connection pad 330 and a bottom of the fourth opening, to expose the upper surface of the first connection pad 330. In addition, the deepened fourth opening exposes the upper surface and/or the sidewall of the second connection pad 430. In an etching process, the first connection pad 330 may protect the first dielectric layer and the second dielectric layer below the first connection pad 330.

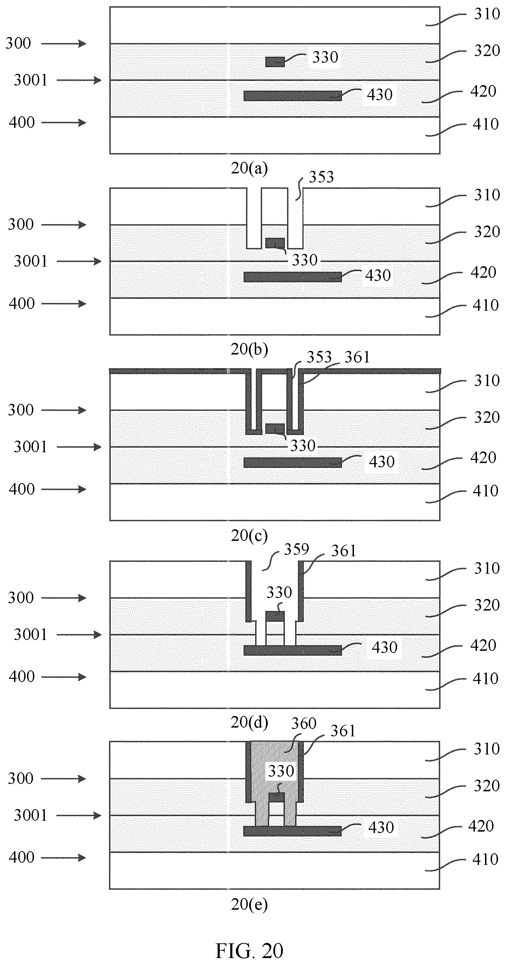

As shown in FIG. 20, the sidewall on a plurality of sides of the second connection pad 430 exceeds the sidewall of the first connection pad 330. As shown in FIG. 20(b), etching is performed from the back surface of the first wafer 300, that is, etching is performed from the back surface of the first substrate 310. An etching position is around the first connection pad 330. Etching is stopped in a position of the lower surface or the upper surface of the first connection pad 330, to obtain the fourth opening 353. Then, as shown in FIG. 20(c), the insulation layer 361 is deposited to protect the sidewall of the fourth opening 353. As shown in FIG. 20(d), etching is performed on the first dielectric layer 320 of the part above the first connection pad 330 and the first dielectric layer 320 and the second dielectric layer 420 at the bottom of the fourth opening 353 around the first connection pad 330, to expose the upper surface and the sidewall of the first connection pad 330 and the upper surface of the second connection pad 430, thereby forming the vertical through hole 359.

In the foregoing method for forming the vertical through hole 359, when etching is performed for the vertical through hole 359, the first connection pad 330 of the upper wafer is used as a blocking layer; and etching is stopped when the second connection pad 430 of the lower wafer is exposed. Generally, the first connection pad 330 is made of a conductive material that may be set to a material with relatively large etch selectivity for the first dielectric layer and the second dielectric layer, for example, a metal material or a doped semiconductor material. Etching selectivity between metal and a dielectric layer is relatively large, for example, SiO₂:Al is close to 20:1, and SiO₂:W is close to 80:1. Therefore, the first connection pad 330 and the second connection pad 430 are not greatly damaged, to ensure that the first connection pad 330 still exists before etching is performed on the second connection pad 430 until etching is performed on both the first dielectric layer 320 and the second dielectric layer 420. Etching is stopped at the second connection pad 430 of the lower wafer. The etching process is relatively simple.

S103: Fill a conductive material in the vertical through hole 359 to form a contact plug 360, with reference to FIG. 16(e), FIG. 17(e), FIG. 18(e), FIG. 19(e), and FIG. 20(e).

In this embodiment of this application, etching may be performed from the upper surface of the first wafer 300, to form the vertical through hole 359. The vertical through hole 359 exposes the upper surface of the first connection pad 330 and the upper surface and/or the sidewall of the second connection pad 430. In this case, after metal is filled in the vertical through hole 359, the formed contact plug 360 is in contact with the upper surface of the first connection pad 330, and also in contact with the upper surface and/or the sidewall of the second connection pad 430. In other words, the formed contact plug 360 is in contact with both the first connection pad 330 and the second connection pad 430, to implement an electrical connection between the first connection pad 330 and the second connection pad 430.

The contact plug 360 is formed in the vertical through hole 359. A conductive material may be filled in the vertical through hole 359 in an electroplating manner or a deposition manner. Then, the conductive material outside the vertical through hole 359 is removed by using a planarization process, for example, a chemical mechanical polishing process, to form the contact plug 360. A material of the contact plug 360 may be copper or aluminum, or may be another conductive metal material or a non-metal material, for example, may be doped silicon.

In the manufacturing method of a semiconductor device provided in this embodiment of this application, the first wafer and the second wafer that are bonded are provided. The first wafer includes the first dielectric layer. The first dielectric layer has the first connection pad. The second wafer includes the second dielectric layer. The second dielectric layer has the second connection pad. The first connection pad is used as a blocking layer. Etching is performed on the first wafer from top to bottom to form the vertical through hole. The vertical through hole passes through the first wafer to the upper surface of the first connection pad, passes through the second wafer to the second connection pad along the sidewall of the first connection pad, and exposes the upper surface and/or the sidewall of the second connection pad. The conductive material is filled in the vertical through hole to form the contact plug. In other words, the vertical through hole may expose the upper surface of the first wafer and the upper surface and/or the sidewall of the second connection pad. In this way, the contact plug in the vertical through hole may be in contact with both the first connection pad and the second connection pad, to implement an electrical connection between the first connection pad and the second connection pad. The contact plug is used as a signal transmission path between the first connection pad and the second connection pad. This path is relatively short. Therefore, a signal delay is reduced. In addition, the vertical through hole is formed by using an etching process, and passes through the sidewall of the first connection pad to the second connection pad. The contact plug may be in contact with the second connection pad from the periphery of the first connection pad, to implement a reliable connection between the contact plug and the second connection pad by using a simple process. In addition, in this embodiment of this application, only one metal plug exists, and therefore, a distance between two metal plugs does not need to be considered. Therefore, a horizontal dimension may be reduced to some extent, to reduce a device size and improve device integration.

It should be noted that mutual reference may be made among the embodiments of this application. For the apparatus embodiment, refer to descriptions of the method embodiment. For the method embodiment, refer to descriptions of the apparatus embodiment.

## Claims

1. A semiconductor device, comprising: a first wafer, a second wafer, and a contact plug, wherein
the first wafer comprises a first dielectric layer, and the first dielectric layer has a first connection pad;
the second wafer is bonded to the first wafer, the second wafer comprises a second dielectric layer, and the second dielectric layer has a second connection pad; and
the contact plug is made of a conductive material filled in a vertical through hole, and is configured to electrically connect the first connection pad and the second connection pad; the vertical through hole is a through hole that is formed through etching and that passes through the first wafer and partially passes through the second wafer to an upper surface and
a sidewall of the second connection pad; and the first connection pad is located in the vertical through hole, and etching is not performed on the first dielectric layer located below the first connection pad;
wherein in the vertical through hole, the first dielectric layer is retained on the sidewall of the first connection pad.

2. The semiconductor device according to claim 1, wherein the second connection pad is disposed opposite to the first connection pad in a vertical direction, and the sidewall on at least one side of the second connection pad exceeds a sidewall of the first connection pad in a horizontal direction, wherein and the vertical through hole exposes the upper surface adjacent to the sidewall on the at least one side of the second connection pad, or the adjacent upper surface and the sidewall on the at least one side of the second connection pad.

3. The semiconductor device according to claim 1 or 2, wherein the second connection pad is disposed opposite to the first connection pad in a vertical direction, and the sidewall on at least one side of the second connection pad is flush with a sidewall of the first connection pad, wherein the vertical through hole exposes the sidewall on the at least one side of the second connection pad and the sidewall that is of the first connection pad and that is flush with the second connection pad.

4. The semiconductor device according to claim 1, wherein the second connection pad and the first connection pad are disposed in a staggered manner in a vertical direction, and a size of a top opening of the vertical through hole is greater than or equal to a horizontal distance between the second connection pad and the first connection pad.

5. The semiconductor device according to any one of claims 1 to 4, further comprising a third wafer, wherein
the third wafer has a third connection pad, and the third wafer is bonded to the first wafer, to implement an electrical connection between the third connection pad and the contact plug.

6. The semiconductor device according to any one of claims 1 to 5, wherein the vertical through hole passes through a direction of the sidewall on a plurality of sides of the first connection pad.

7. A manufacturing method of a semiconductor device, comprising:
providing a first wafer and a second wafer that are bonded, wherein the first wafer comprises a first dielectric layer, the first dielectric layer has a first connection pad, the second wafer comprises a second dielectric layer, and the second dielectric layer has a second connection pad;
using the first connection pad as a blocking layer, and etching the first wafer from top to bottom to form a vertical through hole, wherein the vertical through hole passes through the first wafer to an upper surface of the first connection pad, passes through the second wafer to the second connection pad along a sidewall of the first connection pad, and exposes an upper surface and
a sidewall of the second connection pad, and wherein in the vertical through hole, the first dielectric layer is retained on the sidewall of the first connection pad; and
filling a conductive material in the vertical through hole to form a contact plug, wherein the contact plug is configured to implement an electrical connection between the first connection pad and the second connection pad.

8. The method according to claim 7, wherein the second connection pad is disposed opposite to the first connection pad in a vertical direction, and the using the first connection pad as a blocking layer, and etching the first wafer from top to bottom to form a vertical through hole comprises:
performing etching from an upper surface of the first wafer to obtain a first opening, wherein the first opening is located above the first connection pad, and a sidewall on at least one side of the first opening exceeds the sidewall of the first connection pad in a horizontal direction;
forming a second opening by etching a bottom in a position in which the sidewall of the first opening exceeds the sidewall of the first connection pad in the horizontal direction; and
using the first connection pad as the blocking layer, and deepening the first opening and the second opening, so that the deepened first opening exposes the upper surface of the first connection pad, and the deepened second opening exposes the upper surface and/or the sidewall of the second connection pad,
preferably wherein when the sidewall of the first opening exceeds the sidewall of the first connection pad in the horizontal direction, the sidewall on at least one side of the second connection pad exceeds the sidewall of the first connection pad in the horizontal direction, wherein the deepened second opening exposes the upper surface adjacent to the sidewall that is of the second connection pad and that exceeds the sidewall of the first connection pad in the horizontal direction, or the sidewall that is of the second connection pad and that exceeds the sidewall of the first connection pad in the horizontal direction and the upper surface adjacent to the sidewall of the second connection pad; and/or
when the sidewall of the first opening exceeds the sidewall of the first connection pad in the horizontal direction, the sidewall on at least one side of the second connection pad is flush with the sidewall of the first connection pad, wherein the deepened second opening exposes the sidewall that is of the second connection pad and that is flush with the first connection pad.

9. The method according to claim 8, wherein when the sidewall of the second connection pad exceeds the sidewall on at least one side of the first connection pad in the horizontal direction, the first dielectric layer is reserved on the sidewall of the first connection pad in the deepened second opening.

10. The method according to claim 7, wherein the second connection pad is disposed opposite to the first connection pad in a vertical direction, the first dielectric layer has a third opening, and the using the first connection pad as a blocking layer, and etching the first wafer from top to bottom to form a vertical through hole comprises:
performing etching from an upper surface of the first wafer to obtain a first opening, wherein the first opening is located above the first connection pad, and a sidewall on at least one side of the first opening exceeds the sidewall of the first connection pad in a horizontal direction; and
using the first connection pad as the blocking layer, and etching the first dielectric layer and the second dielectric layer at a bottom of the first opening, so that the deepened first opening is connected to the third opening, the third opening is deepened in the etching process, the deepened first opening exposes the upper surface of the first connection pad, and the deepened third opening exposes the upper surface and/or the sidewall of the second connection pad,
preferably wherein when the sidewall of the first opening exceeds the sidewall of the first connection pad in the horizontal direction, the sidewall on at least one side of the second connection pad exceeds the sidewall of the first connection pad in the horizontal direction, wherein the deepened third opening exposes the upper surface adjacent to the sidewall that is of the second connection pad and that exceeds the sidewall of the first connection pad in the horizontal direction, or the sidewall that is of the second connection pad and that exceeds the sidewall of the first connection pad in the horizontal direction and the upper surface adjacent to the sidewall of the second connection pad; and/or
when the sidewall of the first opening exceeds the sidewall of the first connection pad in the horizontal direction, the sidewall on at least one side of the second connection pad is flush with the sidewall of the first connection pad, wherein the deepened third opening exposes the sidewall that is of the second connection pad and that is flush with the first connection pad.

11. The method according to claim 10, wherein when the sidewall of the second connection pad exceeds the sidewall on at least one side of the first connection pad in the horizontal direction, the first dielectric layer is reserved on the sidewall of the first connection pad in the deepened third opening.

12. The method according to claim 7, wherein the second connection pad is disposed opposite to the first connection pad in a vertical direction, and the using the first connection pad as a blocking layer, and etching the first wafer from top to bottom to form a vertical through hole comprises:
performing etching from an upper surface of the first wafer to obtain a first opening, wherein the first opening is located above the first connection pad, and a sidewall on at least one side of the first opening exceeds the sidewall of the first connection pad in a horizontal direction; and
using the first connection pad as the blocking layer, and deepening the first opening, so that the deepened first opening exposes the upper surface of the first connection pad, and the upper surface and/or the sidewall of the second connection pad,
preferably wherein when the sidewall of the first opening exceeds the sidewall of the first connection pad in the horizontal direction, the sidewall on at least one side of the second connection pad exceeds the sidewall of the first connection pad in the horizontal direction, wherein the deepened first opening exposes the upper surface adjacent to the sidewall that is of the second connection pad and that exceeds the sidewall of the first connection pad in the horizontal direction, or the sidewall that is of the second connection pad and that exceeds the sidewall of the first connection pad in the horizontal direction and the upper surface adjacent to the sidewall of the second connection pad; and/or
when the sidewall of the first opening exceeds the sidewall of the first connection pad in the horizontal direction, the sidewall on at least one side of the second connection pad is flush with the sidewall of the first connection pad, wherein the deepened first opening exposes the sidewall that is of the second connection pad and that is flush with the first connection pad.

13. The method according to claim 7, wherein the second connection pad is disposed opposite to the first connection pad in a vertical direction, and the using the first connection pad as a blocking layer, and etching the first wafer from top to bottom to form a vertical through hole comprises:
performing etching from an upper surface of the first wafer to obtain a fourth opening, wherein a sidewall on at least one side of the fourth opening exceeds the sidewall of the first connection pad; and
using the first connection pad as the blocking layer, and performing etching above the first connection pad and on a bottom of the fourth opening to expose the upper surface of the first connection pad, wherein the deepened fourth opening exposes the upper surface and/or the sidewall of the second connection pad,
preferably wherein when the sidewall of the fourth opening exceeds the sidewall of the first connection pad in the horizontal direction, the sidewall on at least one side of the second connection pad exceeds the sidewall of the first connection pad in the horizontal direction, wherein the deepened fourth opening exposes the upper surface adjacent to the sidewall that is of the second connection pad and that exceeds the sidewall of the first connection pad in the horizontal direction, or the sidewall that is of the second connection pad and that exceeds the sidewall of the first connection pad in the horizontal direction and the upper surface adjacent to the sidewall of the second connection pad; and/or
when the sidewall of the fourth opening exceeds the sidewall of the first connection pad in the horizontal direction, the sidewall on at least one side of the second connection pad is flush with the sidewall of the first connection pad, wherein the deepened fourth opening exposes the sidewall that is of the second connection pad and that is flush with the first connection pad.

14. The method according to any one of claims 7 to 13, wherein the filling a conductive material in the vertical through hole to form a contact plug comprises:
filling the conductive material in the vertical through hole and on the upper surface of the first wafer by using an electroplating process or a deposition process; and
removing the conductive material on the upper surface of the first wafer by using a planarization process, to form the contact plug in the vertical through hole.

## Patentansprüche

1. Halbleitervorrichtung, umfassend: einen ersten Wafer, einen zweiten Wafer und einen Kontaktstecker, wobei
der erste Wafer eine erste dielektrische Schicht umfasst und die erste dielektrische Schicht ein erstes Anschlusspad aufweist; der zweite Wafer mit dem ersten Wafer gebondet ist, wobei der zweite Wafer eine zweite dielektrische Schicht umfasst und die zweite dielektrische Schicht ein zweites Anschlusspad aufweist; und der Kontaktstecker aus einem leitenden Material hergestellt ist, das in ein vertikales Durchgangsloch gefüllt ist, und dazu konfiguriert ist, das erste Anschlusspad und das zweite Anschlusspad elektrisch zu verbinden; wobei das vertikale Durchgangsloch ein Durchgangsloch ist, das durch Ätzen gebildet wird und das durch den ersten Wafer und teilweise durch den zweiten Wafer bis zu einer oberen Oberfläche und einer Seitenwand des zweiten Anschlusspads verläuft; und wobei sich das erste Anschlusspad in dem vertikalen Durchgangsloch befindet und das Ätzen nicht an der ersten dielektrischen Schicht, die sich unterhalb des ersten Anschlusspads befindet, durchgeführt wird;
wobei in dem vertikalen Durchgangsloch die erste dielektrische Schicht an der Seitenwand des ersten Anschlusspads gehalten wird.

2. Halbleitervorrichtung nach Anspruch 1, wobei das zweite Anschlusspad in einer vertikalen Richtung gegenüber dem ersten Anschlusspad angeordnet ist und die Seitenwand auf mindestens einer Seite des zweiten Anschlusspads eine Seitenwand des ersten Anschlusspads in einer horizontaler Richtung überragt, wobei und das vertikale Durchgangsloch die obere Oberfläche angrenzend an die Seitenwand auf der mindestens einen Seite des zweiten Anschlusspads oder die angrenzende obere Oberfläche und die Seitenwand auf der mindestens einen Seite des zweiten Anschlusspads freilegt.

3. Halbleitervorrichtung nach Anspruch 1 oder 2, wobei das zweite Anschlusspad in einer vertikalen Richtung gegenüber dem ersten Anschlusspad angeordnet ist und die Seitenwand auf mindestens einer Seite des zweiten Anschlusspads bündig mit einer Seitenwand des ersten Anschlusspads ist, wobei das vertikale Durchgangsloch die Seitenwand auf der mindestens einen Seite des zweiten Anschlusspads und die Seitenwand des ersten Anschlusspads, welche bündig mit dem zweiten Anschlusspad ist, freilegt.

4. Halbleitervorrichtung nach Anspruch 1, wobei das zweite Anschlusspad und das erste Anschlusspad in einer vertikalen Richtung versetzt angeordnet sind und eine Größe einer oberen Öffnung des vertikalen Durchgangslochs größer als oder gleich einem horizontalen Abstand zwischen dem zweiten Anschlusspad und dem ersten Anschlusspad ist.

5. Halbleitervorrichtung nach einem der Ansprüche 1 bis 4, ferner umfassend einen dritten Wafer, wobei
der dritte Wafer ein drittes Anschlusspad aufweist und der dritte Wafer mit dem ersten Wafer gebondet ist, um eine elektrische Verbindung zwischen dem dritten Anschlusspad und dem Kontaktstecker umzusetzen.

6. Halbleitervorrichtung nach einem der Ansprüche 1 bis 5, wobei das vertikale Durchgangsloch durch eine Richtung der Seitenwand auf einer Vielzahl von Seiten des ersten Anschlusspads verläuft.

7. Herstellungsverfahren für eine Halbleitervorrichtung, umfassend:
Bereitstellen eines ersten Wafers und eines zweiten Wafers, die miteinander gebondet sind, wobei der erste Wafer eine erste dielektrische Schicht umfasst, die erste dielektrische Schicht ein erstes Anschlusspad aufweist, der zweite Wafer eine zweite dielektrische Schicht umfasst und die zweite dielektrische Schicht ein zweites Anschlusspad aufweist;
Verwenden des ersten Anschlusspads als eine Sperrschicht und Ätzen des ersten Wafers von oben nach unten, um ein vertikales Durchgangsloch zu bilden, wobei das vertikale Durchgangsloch durch den ersten Wafer zu einer oberen Oberfläche des ersten Anschlusspads verläuft, entlang einer Seitenwand des ersten Anschlusspads durch den zweiten Wafer zu dem zweiten Anschlusspad verläuft und eine obere Oberfläche und eine Seitenwand des zweiten Anschlusspads freilegt und wobei, in dem vertikalen Durchgangsloch, die erste dielektrische Schicht an der Seitenwand des ersten Anschlusspads gehalten wird; und
Füllen eines leitenden Materials in das vertikale Durchgangsloch, um einen Kontaktstecker zu bilden, wobei der Kontaktstecker dazu konfiguriert ist, eine elektrische Verbindung zwischen dem ersten Anschlusspad und dem zweiten Anschlusspad umzusetzen.

8. Verfahren nach Anspruch 7, wobei das zweite Anschlusspad in einer vertikalen Richtung gegenüber dem ersten Anschlusspad angeordnet ist und das Verwenden des ersten Anschlusspads als eine Sperrschicht und das Ätzen des ersten Wafers von oben nach unten, um ein vertikales Durchgangsloch zu bilden, Folgendes umfasst:
Durchführen des Ätzens von einer oberen Oberfläche des ersten Wafers, um eine erste Öffnung zu erlangen, wobei sich die erste Öffnung oberhalb des ersten Anschlusspads befindet und eine Seitenwand auf mindestens einer Seite der ersten Öffnung die Seitenwand des ersten Anschlusspads in einer horizontalen Richtung überragt;
Bilden einer zweiten Öffnung durch Ätzen eines Bodens an einer Stelle, an der die Seitenwand der ersten Öffnung die Seitenwand des ersten Anschlusspads in der horizontalen Richtung überragt; und
Verwenden des ersten Anschlusspads als die Sperrschicht und Vertiefen der ersten Öffnung und der zweiten Öffnung, so dass die vertiefte erste Öffnung die obere Oberfläche des ersten Anschlusspads freilegt und die vertiefte zweite Öffnung die obere Oberfläche und/oder die Seitenwand des zweiten Anschlusspads freilegt,
wobei bevorzugt, wenn die Seitenwand der ersten Öffnung die Seitenwand des ersten Anschlusspads in der horizontalen Richtung überragt, die Seitenwand auf mindestens einer Seite des zweiten Anschlusspads die Seitenwand des ersten Anschlusspads in der horizontalen Richtung überragt, wobei die vertiefte zweite Öffnung die obere Oberfläche angrenzend an die Seitenwand des zweiten Anschlusspads, welche die Seitenwand des ersten Anschlusspads in der horizontalen Richtung überragt, oder die Seitenwand des zweiten Anschlusspads, welche die Seitenwand des ersten Anschlusspads in der horizontalen Richtung überragt, und die obere Oberfläche angrenzend an die Seitenwand des zweiten Anschlusspads freilegt; und/oder
wenn die Seitenwand der ersten Öffnung die Seitenwand des ersten Anschlusspads in der horizontalen Richtung überragt, die Seitenwand auf mindestens einer Seite des zweiten Anschlusspads bündig mit der Seitenwand des ersten Anschlusspads ist,
wobei die vertiefte zweite Öffnung die Seitenwand des zweiten Anschlusspads, welche bündig mit dem ersten Anschlusspad ist, freilegt.

9. Verfahren nach Anspruch 8, wobei, wenn die Seitenwand des zweiten Anschlusspads die Seitenwand auf mindestens einer Seite des ersten Anschlusspads in der horizontalen Richtung überragt, die erste dielektrische Schicht auf der Seitenwand des ersten Anschlusspads in der vertieften zweiten Öffnung erhalten bleibt.

10. Verfahren nach Anspruch 7, wobei das zweite Anschlusspad in einer vertikalen Richtung gegenüber dem ersten Anschlusspad angeordnet ist, die erste dielektrische Schicht eine dritte Öffnung aufweist und das Verwenden des ersten Anschlusspads als eine Sperrschicht und das Ätzen des ersten Wafers von oben nach unten, um ein vertikales Durchgangsloch zu bilden, Folgendes umfasst:
Durchführen des Ätzens von einer oberen Oberfläche des ersten Wafers, um eine erste Öffnung zu erlangen, wobei sich die erste Öffnung oberhalb des ersten Anschlusspads befindet und eine Seitenwand auf mindestens einer Seite der ersten Öffnung die Seitenwand des ersten Anschlusspads in einer horizontalen Richtung überragt; und
Verwenden des ersten Anschlusspads als die Sperrschicht und Ätzen der ersten dielektrischen Schicht und der zweiten dielektrischen Schicht an einem Boden der ersten Öffnung, so dass die vertiefte erste Öffnung mit der dritten Öffnung verbunden ist, die dritte Öffnung in dem Ätzprozess vertieft wird, die vertiefte erste Öffnung die obere Oberfläche des ersten Anschlusspads freilegt und die vertiefte dritte Öffnung die obere Oberfläche und/oder die Seitenwand des zweiten Anschlusspads freilegt,
wobei bevorzugt, wenn die Seitenwand der ersten Öffnung die Seitenwand des ersten Anschlusspads in der horizontalen Richtung überragt, die Seitenwand auf mindestens einer Seite des zweiten Anschlusspads die Seitenwand des ersten Anschlusspads in der horizontalen Richtung überragt, wobei die vertiefte dritte Öffnung die obere Oberfläche angrenzend an die Seitenwand des zweiten Anschlusspads, welche die Seitenwand des ersten Anschlusspads in der horizontalen Richtung überragt, oder die Seitenwand des zweiten Anschlusspads, welche die Seitenwand des ersten Anschlusspads in der horizontalen Richtung überragt, und die obere Oberfläche angrenzend an die Seitenwand des zweiten Anschlusspads freilegt; und/oder
wenn die Seitenwand der ersten Öffnung die Seitenwand des ersten Anschlusspads in der horizontalen Richtung überragt, die Seitenwand auf mindestens einer Seite des zweiten Anschlusspads bündig mit der Seitenwand des ersten Anschlusspads ist, wobei die vertiefte dritte Öffnung die Seitenwand des zweiten Anschlusspads, welche bündig mit dem ersten Anschlusspad ist, freilegt.

11. Verfahren nach Anspruch 10, wobei, wenn die Seitenwand des zweiten Anschlusspads die Seitenwand auf mindestens einer Seite des ersten Anschlusspads in der horizontalen Richtung überragt, die erste dielektrische Schicht auf der Seitenwand des ersten Anschlusspads in der vertieften dritten Öffnung erhalten bleibt.

12. Verfahren nach Anspruch 7, wobei das zweite Anschlusspad in einer vertikalen Richtung gegenüber dem ersten Anschlusspad angeordnet ist und das Verwenden des ersten Anschlusspads als eine Sperrschicht und das Ätzen des ersten Wafers von oben nach unten, um ein vertikales Durchgangsloch zu bilden, Folgendes umfasst:
Durchführen des Ätzens von einer oberen Oberfläche des ersten Wafers, um eine erste Öffnung zu erlangen, wobei sich die erste Öffnung oberhalb des ersten Anschlusspads befindet und eine Seitenwand auf mindestens einer Seite der ersten Öffnung die Seitenwand des ersten Anschlusspads in einer horizontalen Richtung überragt; und
Verwenden des ersten Anschlusspads als die Sperrschicht und Vertiefen der ersten Öffnung, so dass die vertiefte erste Öffnung die obere Oberfläche des ersten Anschlusspads und die obere Oberfläche und/oder die Seitenwand des zweiten Anschlusspads freilegt,
wobei bevorzugt, wenn die Seitenwand der ersten Öffnung die Seitenwand des ersten Anschlusspads in der horizontalen Richtung überragt, die Seitenwand auf mindestens einer Seite des zweiten Anschlusspads die Seitenwand des ersten Anschlusspads in der horizontalen Richtung überragt, wobei die vertiefte erste Öffnung die obere Oberfläche angrenzend an die Seitenwand des zweiten Anschlusspads, welche die Seitenwand des ersten Anschlusspads in der horizontalen Richtung überragt, oder die Seitenwand des zweiten Anschlusspads, welche die Seitenwand des ersten Anschlusspads in der horizontalen Richtung überragt, und die obere Oberfläche angrenzend an die Seitenwand des zweiten Anschlusspads freilegt; und/oder
wenn die Seitenwand der ersten Öffnung die Seitenwand des ersten Anschlusspads in der horizontalen Richtung überragt, die Seitenwand auf mindestens einer Seite des zweiten Anschlusspads bündig mit der Seitenwand des ersten Anschlusspads ist, wobei die vertiefte erste Öffnung die Seitenwand des zweiten Anschlusspads, welche bündig mit dem ersten Anschlusspad ist, freilegt.

13. Verfahren nach Anspruch 7, wobei das zweite Anschlusspad in einer vertikalen Richtung gegenüber dem ersten Anschlusspad angeordnet ist und das Verwenden des ersten Anschlusspads als eine Sperrschicht und das Ätzen des ersten Wafers von oben nach unten, um ein vertikales Durchgangsloch zu bilden, Folgendes umfasst:
Durchführen des Ätzens von einer oberen Oberfläche des ersten Wafers, um eine vierte Öffnung zu erlangen, wobei eine Seitenwand auf mindestens einer Seite der vierten Öffnung die Seitenwand des ersten Anschlusspads überragt; und
Verwenden des ersten Anschlusspads als die Sperrschicht und Durchführen des Ätzens oberhalb des ersten Anschlusspads und auf einem Boden der vierten Öffnung, um die obere Oberfläche des ersten Anschlusspads freizulegen, wobei die vertiefte vierte Öffnung die obere Oberfläche und/oder die Seitenwand des zweiten Anschlusspads freilegt,
wobei bevorzugt, wenn die Seitenwand der vierten Öffnung die Seitenwand des ersten Anschlusspads in der horizontalen Richtung überragt, die Seitenwand auf mindestens einer Seite des zweiten Anschlusspads die Seitenwand des ersten Anschlusspads in der horizontalen Richtung überragt, wobei die vertiefte vierte Öffnung die obere Oberfläche angrenzend an die Seitenwand des zweiten Anschlusspads, welche die Seitenwand des ersten Anschlusspads in der horizontalen Richtung überragt, oder die Seitenwand des zweiten Anschlusspads, welche die Seitenwand des ersten Anschlusspads in der horizontalen Richtung überragt, und die obere Oberfläche angrenzend an die Seitenwand des zweiten Anschlusspads freilegt; und/oder
wenn die Seitenwand der vierten Öffnung die Seitenwand des ersten Anschlusspads in der horizontalen Richtung überragt, die Seitenwand auf mindestens einer Seite des zweiten Anschlusspads bündig mit der Seitenwand des ersten Anschlusspads ist, wobei die vertiefte vierte Öffnung die Seitenwand des zweiten Anschlusspads, welche bündig mit dem ersten Anschlusspad ist, freilegt.

14. Verfahren nach einem der Ansprüche 7 bis 13, wobei das Füllen eines leitenden Materials in das vertikale Durchgangsloch, um einen Kontaktstecker zu bilden, Folgendes umfasst:
Füllen des leitenden Materials in das vertikale Durchgangsloch und auf die obere Oberfläche des ersten Wafers unter Verwendung eines Galvanisierungsprozesses oder eines Abscheidungsprozesses; und
Entfernen des leitenden Materials auf der oberen Oberfläche des ersten Wafers unter Verwendung eines Planarisierungsprozesses, um den Kontaktstecker in dem vertikalen Durchgangsloch zu bilden.

## Revendications

1. Dispositif semi-conducteur, comprenant : une première plaquette, une deuxième plaquette et une fiche de contact, dans lequel
la première plaquette comprend une première couche diélectrique, et la première couche diélectrique a un premier plot de connexion ;
la deuxième plaquette est liée à la première plaquette, la deuxième plaquette comprend une seconde couche diélectrique, et la seconde couche diélectrique a un deuxième plot de connexion ; et
la fiche de contact est constituée d'un matériau conducteur rempli dans un trou traversant vertical, et est configurée pour connecter électriquement le premier plot de connexion et le deuxième plot de connexion ; le trou traversant vertical est un trou traversant qui est formé par gravure et qui passe à travers la première plaquette et qui passe partiellement à travers la deuxième plaquette jusqu'à une surface supérieure et
une paroi latérale du deuxième plot de connexion ; et le premier plot de connexion est situé dans le trou traversant vertical, et la gravure n'est pas réalisée sur la première couche diélectrique située sous le premier plot de connexion ;
dans lequel, dans le trou traversant vertical, la première couche diélectrique est retenue sur la paroi latérale du premier plot de connexion.

2. Dispositif semi-conducteur selon la revendication 1, dans lequel le deuxième plot de connexion est disposé à l'opposé du premier plot de connexion dans une direction verticale, et la paroi latérale sur au moins un côté du deuxième plot de connexion dépasse une paroi latérale du premier plot de connexion dans une direction horizontale, dans lequel le trou traversant vertical expose la surface supérieure adjacente à la paroi latérale sur l'au moins un côté du deuxième plot de connexion, ou la surface supérieure adjacente et la paroi latérale sur l'au moins un côté du deuxième plot de connexion.

3. Dispositif semi-conducteur selon la revendication 1 ou 2, dans lequel le deuxième plot de connexion est disposé à l'opposé du premier plot de connexion dans une direction verticale, et la paroi latérale sur au moins un côté du deuxième plot de connexion affleure une paroi latérale du premier plot de connexion, dans lequel le trou traversant vertical expose la paroi latérale sur l'au moins un côté du deuxième plot de connexion et la paroi latérale qui est du premier plot de connexion et qui affleure le deuxième plot de connexion.

4. Dispositif semi-conducteur selon la revendication 1, dans lequel le deuxième plot de connexion et le premier plot de connexion sont disposés de manière décalée dans une direction verticale, et une taille d'une ouverture supérieure du trou traversant vertical est supérieure ou égale à une distance horizontale entre le deuxième plot de connexion et le premier plot de connexion.

5. Dispositif semi-conducteur selon l'une quelconque des revendications 1 à 4, comprenant également une troisième plaquette, dans lequel
la troisième plaquette a un troisième plot de connexion, et la troisième plaquette est liée à la première plaquette, pour mettre en œuvre une connexion électrique entre le troisième plot de connexion et la fiche de contact.

6. Dispositif semi-conducteur selon l'une quelconque des revendications 1 à 5, dans lequel le trou traversant vertical passe à travers une direction de la paroi latérale sur une pluralité de côtés du premier plot de connexion.

7. Procédé de fabrication d'un dispositif semi-conducteur, comprenant :
la fourniture d'une première plaquette et d'une deuxième plaquette qui sont liées, dans lequel la première plaquette comprend une première couche diélectrique, la première couche diélectrique a un premier plot de connexion, la deuxième plaquette comprend une seconde couche diélectrique, et la seconde couche diélectrique a un deuxième plot de connexion ;
l'utilisation du premier plot de connexion comme couche de blocage, et la gravure de la première plaquette de haut en bas pour former un trou traversant vertical, dans lequel le trou traversant vertical passe à travers la première plaquette jusqu'à une surface supérieure du premier plot de connexion, passe à travers la deuxième plaquette jusqu'au deuxième plot de connexion le long d'une paroi latérale du premier plot de connexion, et expose une surface supérieure et
une paroi latérale du deuxième plot de connexion, et dans lequel dans le trou traversant vertical, la première couche diélectrique est retenue sur la paroi latérale du premier plot de connexion ; et
le remplissage d'un matériau conducteur dans le trou traversant vertical pour former une fiche de contact, dans lequel la fiche de contact est configurée pour mettre en œuvre une connexion électrique entre le premier plot de connexion et le deuxième plot de connexion.

8. Procédé selon la revendication 7, dans lequel le deuxième plot de connexion est disposé à l'opposé du premier plot de connexion dans une direction verticale, et l'utilisation du premier plot de connexion comme couche de blocage, et la gravure de la première plaquette de haut en bas pour former un trou traversant vertical comprend :
la réalisation d'une gravure à partir d'une surface supérieure de la première plaquette pour obtenir une première ouverture, dans lequel la première ouverture est située au-dessus du premier plot de connexion, et une paroi latérale sur au moins un côté de la première ouverture dépasse la paroi latérale du premier plot de connexion dans une direction horizontale ;
la formation d'une deuxième ouverture en gravant un fond à un emplacement dans lequel la paroi latérale de la première ouverture dépasse la paroi latérale du premier plot de connexion dans la direction horizontale ; et
l'utilisation du premier plot de connexion comme couche de blocage, et l'approfondissement de la première ouverture et de la deuxième ouverture, de sorte que la première ouverture approfondie expose la surface supérieure du premier plot de connexion, et que la deuxième ouverture approfondie expose la surface supérieure et/ou la paroi latérale du deuxième plot de connexion,
de préférence dans lequel lorsque la paroi latérale de la première ouverture dépasse la paroi latérale du premier plot de connexion dans la direction horizontale, la paroi latérale sur au moins un côté du deuxième plot de connexion dépasse la paroi latérale du premier plot de connexion dans la direction horizontale, dans lequel la deuxième ouverture approfondie expose la surface supérieure adjacente à la paroi latérale qui est du deuxième plot de connexion et qui dépasse la paroi latérale du premier plot de connexion dans la direction horizontale, ou la paroi latérale qui est du deuxième plot de connexion et qui dépasse la paroi latérale du premier plot de connexion dans la direction horizontale et la surface supérieure adjacente à la paroi latérale du deuxième plot de connexion ; et/ou
lorsque la paroi latérale de la première ouverture dépasse la paroi latérale du premier plot de connexion dans la direction horizontale, la paroi latérale sur au moins un côté du deuxième plot de connexion affleure la paroi latérale du premier plot de connexion,
dans lequel la deuxième ouverture approfondie expose la paroi latérale qui est du deuxième plot de connexion et qui affleure le premier plot de connexion.

9. Procédé selon la revendication 8, dans lequel lorsque la paroi latérale du deuxième plot de connexion dépasse la paroi latérale sur au moins un côté du premier plot de connexion dans la direction horizontale, la première couche diélectrique est réservée sur la paroi latérale du premier plot de connexion dans la deuxième ouverture approfondie.

10. Procédé selon la revendication 7, dans lequel le deuxième plot de connexion est disposé à l'opposé du premier plot de connexion dans une direction verticale, la première couche diélectrique a une troisième ouverture, et l'utilisation du premier plot de connexion comme couche de blocage, et la gravure de la première plaquette de haut en bas pour former un trou traversant vertical comprend :
la réalisation d'une gravure à partir d'une surface supérieure de la première plaquette pour obtenir une première ouverture, dans lequel la première ouverture est située au-dessus du premier plot de connexion, et une paroi latérale sur au moins un côté de la première ouverture dépasse la paroi latérale du premier plot de connexion dans une direction horizontale ; et
l'utilisation du premier plot de connexion comme couche de blocage, et la gravure de la première couche diélectrique et de la seconde couche diélectrique à un fond de la première ouverture, de sorte que la première ouverture approfondie soit connectée à la troisième ouverture, la troisième ouverture est approfondie au cours du processus de gravure, la première ouverture approfondie expose la surface supérieure du premier plot de connexion, et la troisième ouverture approfondie expose la surface supérieure et/ou la paroi latérale du deuxième plot de connexion,
de préférence dans lequel lorsque la paroi latérale de la première ouverture dépasse la paroi latérale du premier plot de connexion dans la direction horizontale, la paroi latérale sur au moins un côté du deuxième plot de connexion dépasse la paroi latérale du premier plot de connexion dans la direction horizontale, dans lequel la troisième ouverture approfondie expose la surface supérieure adjacente à la paroi latérale qui est du deuxième plot de connexion et qui dépasse la paroi latérale du premier plot de connexion dans la direction horizontale, ou la paroi latérale qui est du deuxième plot de connexion et qui dépasse la paroi latérale du premier plot de connexion dans la direction horizontale et la surface supérieure adjacente à la paroi latérale du deuxième plot de connexion ; et/ou
lorsque la paroi latérale de la première ouverture dépasse la paroi latérale du premier plot de connexion dans la direction horizontale, la paroi latérale sur au moins un côté du deuxième plot de connexion affleure la paroi latérale du premier plot de connexion, dans lequel la troisième ouverture approfondie expose la paroi latérale qui est du deuxième plot de connexion et qui affleure le premier plot de connexion.

11. Procédé selon la revendication 10, dans lequel lorsque la paroi latérale du deuxième plot de connexion dépasse la paroi latérale sur au moins un côté du premier plot de connexion dans la direction horizontale, la première couche diélectrique est réservée sur la paroi latérale du premier plot de connexion dans la troisième ouverture approfondie.

12. Procédé selon la revendication 7, dans lequel le deuxième plot de connexion est disposé à l'opposé du premier plot de connexion dans une direction verticale, et l'utilisation du premier plot de connexion comme couche de blocage, et la gravure de la première plaquette de haut en bas pour former un trou traversant vertical comprend :
la réalisation d'une gravure à partir d'une surface supérieure de la première plaquette pour obtenir une première ouverture, dans lequel la première ouverture est située au-dessus du premier plot de connexion, et une paroi latérale sur au moins un côté de la première ouverture dépasse la paroi latérale du premier plot de connexion dans une direction horizontale ; et
l'utilisation du premier plot de connexion comme couche de blocage, et l'approfondissement de la première ouverture, de sorte que la première ouverture approfondie expose la surface supérieure du premier plot de connexion, et la surface supérieure et/ou la paroi latérale du deuxième plot de connexion,
de préférence dans lequel lorsque la paroi latérale de la première ouverture dépasse la paroi latérale du premier plot de connexion dans la direction horizontale, la paroi latérale sur au moins un côté du deuxième plot de connexion dépasse la paroi latérale du premier plot de connexion dans la direction horizontale, dans lequel la première ouverture approfondie expose la surface supérieure adjacente à la paroi latérale qui est du deuxième plot de connexion et qui dépasse la paroi latérale du premier plot de connexion dans la direction horizontale, ou la paroi latérale qui est du deuxième plot de connexion et qui dépasse la paroi latérale du premier plot de connexion dans la direction horizontale et la surface supérieure adjacente à la paroi latérale du deuxième plot de connexion ; et/ou
lorsque la paroi latérale de la première ouverture dépasse la paroi latérale du premier plot de connexion dans la direction horizontale, la paroi latérale sur au moins un côté du deuxième plot de connexion affleure la paroi latérale du premier plot de connexion, dans lequel la première ouverture approfondie expose la paroi latérale qui est du deuxième plot de connexion et qui affleure le premier plot de connexion.

13. Procédé selon la revendication 7, dans lequel le deuxième plot de connexion est disposé à l'opposé du premier plot de connexion dans une direction verticale, et l'utilisation du premier plot de connexion comme couche de blocage, et la gravure de la première plaquette de haut en bas pour former un trou traversant vertical comprend :
la réalisation d'une gravure à partir d'une surface supérieure de la première plaquette pour obtenir une quatrième ouverture, dans lequel une paroi latérale sur au moins un côté de la quatrième ouverture dépasse la paroi latérale du premier plot de connexion ; et
l'utilisation du premier plot de connexion comme couche de blocage, et la réalisation d'une gravure au-dessus du premier plot de connexion et sur un fond de la quatrième ouverture pour exposer la surface supérieure du premier plot de connexion, dans lequel la quatrième ouverture approfondie expose la surface supérieure et/ou la paroi latérale du deuxième plot de connexion,
de préférence dans lequel lorsque la paroi latérale de la quatrième ouverture dépasse la paroi latérale du premier plot de connexion dans la direction horizontale, la paroi latérale sur au moins un côté du deuxième plot de connexion dépasse la paroi latérale du premier plot de connexion dans la direction horizontale, dans lequel la quatrième ouverture approfondie expose la surface supérieure adjacente à la paroi latérale qui est du deuxième plot de connexion et qui dépasse la paroi latérale du premier plot de connexion dans la direction horizontale, ou la paroi latérale qui est du deuxième plot de connexion et qui dépasse la paroi latérale du premier plot de connexion dans la direction horizontale et la surface supérieure adjacente à la paroi latérale du deuxième plot de connexion ; et/ou
lorsque la paroi latérale de la quatrième ouverture dépasse la paroi latérale du premier plot de connexion dans la direction horizontale, la paroi latérale sur au moins un côté du deuxième plot de connexion affleure la paroi latérale du premier plot de connexion, dans lequel la quatrième ouverture approfondie expose la paroi latérale qui est du deuxième plot de connexion et qui affleure le premier plot de connexion.

14. Procédé selon l'une quelconque des revendications 7 à 13, dans lequel le remplissage d'un matériau conducteur dans le trou traversant vertical pour former une fiche de contact comprend :
le remplissage du matériau conducteur dans le trou traversant vertical et sur la surface supérieure de la première plaquette à l'aide d'un processus d'électroplacage ou d'un processus de dépôt ; et
l'élimination du matériau conducteur sur la surface supérieure de la première plaquette à l'aide d'un processus de planarisation, pour former la fiche de contact dans le trou traversant vertical.
